# EUROPÄISCHE PATENTSCHRIFT

(11) **EP 3 918 426 B1**
(45) Veröffentlichungstag und Bekanntmachung des Hinweises auf die Patenterteilung: **26.06.2024**
(21) Anmeldenummer: 19809457.5
(22) Anmeldetag: 25.11.2019
(51) Int. Cl.: G04F 10/00

(54) **VERFAHREN ZUR TIME-TO-DIGITAL-KONVERSION UND TIME-TO-DIGITAL-KONVERTER**
METHOD FOR TIME-TO-DIGITAL CONVERSION AND TIME-TO-DIGITAL CONVERTER
PROCÉDÉ DE CONVERSION TEMPS VERS NUMÉRIQUE ET CONVERTISSEUR TEMPS VERS NUMÉRIQUE

(30) Priorität: 30.01.2019 DE 102019102254
(43) Veröffentlichungstag der Anmeldung: 08.12.2021
(73) Patentinhaber: GSI Helmholtzzentrum für Schwerionenforschung GmbH, 64291 Darmstadt (DE)
(72) Erfinder: KNITTEL, Günter, 53125 Bonn (DE)
(74) Vertreter: Keil & Schaafhausen Patentanwälte PartGmbB
(86) Internationale Anmeldenummer: PCT/EP2019/082430
(87) Internationale Veröffentlichungsnummer: WO 2020/156701

(56) Entgegenhaltungen:
- EP-A2- 0 113 935
- US-A1- 2017 163 279

## Beschreibung

Die Erfindung betrifft ein Verfahren zur Time-to-Digital-Konversion (TDC) nach dem Oberbegriff des Anspruchs 1 und einen zur Durchführung des Verfahrens eingerichteten Time-to-Digital-Konverter, d.h. einer als Time-to-Digital-Konverter ausgebildeten Messvorrichtung, nach dem Oberbegriff des Anspruchs 8. Bei der Zeit-zu-Digitalwert-Konversion wird der Zeitpunkt des Eintreffens eines Signals an einer Messvorrichtung bestimmt und ggf. ausgegeben, bspw. als digitaler Wert. Der Zeitpunkt des Eintreffens wird in einer eigenen Zeiteinheit bestimmt, die der Time-to-Digital-Konversion zugrunde liegt.

Bei der Durchführung des Verfahrens ist vorgesehen, dass das an der Messvorrichtung eintreffende Signal, das bspw. durch ein (von dem Verfahren grundsätzlich unabhängigen) auslösenden Ereignis (bspw. dem Nachweis eines Teilchens in dem Detektor) erzeugt wird, in eine Verzögerungsschaltung aus einer Vielzahl von in Reihe geschalteten Verzögerungselementen eingespeist wird. Jedes der Verzögerungselemente weist mindestens einen (Signal-) Eingang und mindestens einen (Signal-) Ausgang auf, wobei der Ausgang eines Verzögerungselements mit dem Eingang des nachfolgenden Verzögerungselements verbunden ist.

Dadurch wird ein Signal am Eingang jedes der Verzögerungselemente nach einer inhärenten Verzögerungszeit über seinen Ausgang an den Eingang des nachfolgenden Verzögerungselements übertragen.

Grundsätzlich sind derartige Verfahren und Vorrichtungen bekannt. Die US 7,809,521 B1 beschreibt ein Verfahren und eine Vorrichtung zur On-Chip Laufzeitverzögerungsmessung, bei der ein Pulsgenerator, eine Verzögerungsschaltung und ein Austrittszähler zum Einsatz kommen.

Die EP 0 113 935 A2 offenbart eine Zeitgeberschaltung mit einer Taktimpulsgeneratoranordnung, einer Verzögerungsschaltung, mit der ein Ausgang der Taktimpulsgeneratoranordnung gekoppelt ist und die mit n Abgriffen versehen ist, deren Positionen im wesentlichen gleichen Verzögerungsinkrementen T entsprechen. Dabei ist nT größer als sowohl die Länge der Ausgangsimpulse der Taktimpulsgeneratoranordnung als auch die Länge der Intervalle dazwischen, und eine Kopplung von den Abgriffen zu einem Ausgang der Schaltung.

Die US 2017/163279 A1 offenbart einen Analog-Digital-Wandler (ADC), der ein analoges Eingangssignal in ein digitales Ausgangssignal umwandelt, das eine Folge von Bits umfasst, die eine Amplitude des analogen Eingangssignals darstellen. Ein ADC hat typischerweise eine analoge Referenzspannung oder einen analogen Referenzstrom, mit dem das analoge Eingangssignal verglichen wird. Das digitale Ausgangssignal gibt an, welcher Bruchteil der Referenzspannung die Amplitude des analogen Eingangssignals ist.

Die US 2011/0133973 A1 beschreibt ein Verfahren und eine Vorrichtung, bei denen mittels Time-to-Digital-Konversion der Zeitpunkt des Eintreffens von Signalen an einer Messvorrichtung bestimmt wird.

Bei dem für die Erfindung maßgeblichen Signal handelt es um ein diskretes Signal. In Abgrenzung zu einem kontinuierlichen Signal, bei dem alle Werte innerhalb seines Wertebereichs maßgeblich sind, wird unter einem diskreten Signal ein wertediskretes Signal verstanden, bei dem nur bestimmte stabile Signalwerte maßgeblich sind und durch die Schaltung ausgewertet werden. Bei einem digitalen binären Signal sind das zwei (digitale) diskrete Signalwerte, die typischer Weise als 0 und 1 bezeichnet werden und in einem realen, elektrischen Signal durch zwei (analoge) diskrete Signalwerte, bspw. die diskreten Spannungswerte 0 V und 5 V, vorgegeben sein können. Bei einem ternären Signal gibt es drei diskrete Signalwerte. Dies ließe sich beliebig fortsetzen, auch wenn in praktischen Realisierung meist binäre, oder ggf. auch ternäre, Signalwerte gewählt werden.

Die maßgeblichen diskreten Signalwerte werden auch als Pegel bezeichnet, die in einer elektrischen Realisierung durch die diskreten Spannungswerte gebildet sind. Ein Signal - im Sinne eines erkennbaren Ereignisses wie einem auslösenden Ereignis - wird durch einen Pegelwechsel angezeigt, bei dem der Pegel (im Sinne eines diskreten Signalwerts) von einem ersten Signalwert auf einen zweiten Signalwert wechselt.

In technischen Realisierungen erfolgt der Pegelwechsel bei einem Signal typischer Weise nicht instantan, sondern vollzieht sich mit endlicher Geschwindigkeit. Der beobachtbare Vorgang des Pegelwechsels, zum Beispiel auf einem elektrischen Leiter, wird auch als Flanke bezeichnet. Der zeitliche Verlauf eines Signals zwischen zwei Pegelwechseln, also der zeitliche Verlauf des Signals mit einem konstanten maßgeblichen Pegel (entsprechend einem der diskreten Signalwerte), wird als Puls bezeichnet. Die Zeitdauer zwischen zwei Pegelwechseln (Flanken) wird als Pulsdauer bezeichnet.

Durch diese Art der Schaltung wird eine Verzögerungsschaltung realisiert, in der ein einem der Verzögerungselemente an seinem Eingang zugewiesenes Signal (im Sine eines sich bei dem Pegelwechsel ändernder diskreter Signalwert bzw. Pegel) mit einer durch die Bauart bzw. Realisierung der Verzögerungselemente vorgebebenen und damit den Verzögerungselementen inhärenten Verzögerungszeit von einem zu dem nächsten Verzögerungselement durch die Reihe der Verzögerungselemente durchläuft, bis das Signal aus dem letzten der Verzögerungselemente an dessen Ausgang austritt. Das an dem Eingang des Verzögerungselements anliegende Signal kann typischer Weise durch analoge diskrete Signalwerte (Pegel) gebildet sein.

Mit anderen Worten wird ein an dem Eingang eines der Verzögerungselemente eingespeistes Signal, das in dem Verzögerungselement einen Pegelwechsel zwischen einem ersten diskreten Signalwert und einem zweiten diskreten Signalwert hervorruft, als dieser Pegelwechsel also über den Ausgang des Verzögerungselements jeweils an den Eingang des nachfolgenden Verzögerungselements übertragen. Dementsprechend ruft also ein Pegelwechsel an dem Eingang des ersten Verzögerungselements nach einer dem ersten Verzögerungselement inhärenten Verzögerungszeit einen Pegelwechsel an einem Eingang des zweiten Verzögerungselements hervor. Entsprechend wird nach einer dem zweiten Verzögerungselements inhärenten Verzögerungszeit ein Pegelwechsel an einem Eingang des dritten Verzögerungselements hervorgerufen. So wandert der Pegelwechsel mit endlicher Geschwindigkeit von einem Verzögerungselement zum nächsten entlang der in Reihe geschalteten Verzögerungselemente. Nach einer Gesamtverzögerungszeit, die - bei Vernachlässigung anderer Effekte - der Summe aller inhärenten Verzögerungszeiten der einzelnen Verzögerungselemente entspricht, kann am Ausgang des letzten Verzögerungselements ein Pegelwechsel beobachtet werden.

Das Übertragen eines Pegelwechsels erfolgt also dadurch, dass an dem Eingang des Verzögerungselements ein sich ändernder diskreter Signalwert (Pegel) angelegt wird, der sich von dem zuvor angelegten Signalwert (Pegel) unterscheidet. Dieser geänderte Signalwert (Pegel) wird dann nach der inhärenten Verzögerungszeit an dem Ausgang des Verzögerungselements ausgegeben. Hierdurch wird der Pegelwechsel auf das jeweils nächste Verzögerungselement übertragen.

Das Verzögerungselement, in das das Signal (der Pegelwechsel) eingespeist wird, wird nachfolgend auch häufig als das erste Verzögerungselement bezeichnet. Dieses ist vorzugsweise auch das (in der räumlichen Anordnung der Verzögerungsschaltung) erste Verzögerungselement. Dies ist jedoch nicht unbedingt notwendig. Entsprechendes gilt grundsätzlich für das letzte Verzögerungselement, durch das der Pegelwechsel durchläuft.

Der Ausgang jedes Verzögerungselements ist jeweils auch mit einem Eingang eines Registers verbunden. Der an dem Eingang des Registers anliegende diskrete Signalwert (Pegel) wird in einem Systemtakt (insbesondere einem durch ein in einer bestimmten Taktperiode auftretendes Taktsignal vorgegebenen Systemtakt) gespeichert und über einen Ausgang des Registers als diskreter Signalwert (vorzugsweise als digitaler diskreter Signalwert) ausgegeben. Somit ist jedes Verzögerungselement mit einem Register verbunden. Insbesondere kann in einer Messvorrichtung also dieselbe Anzahl von Verzögerungselementen und Registern vorgesehen sein. Die Gesamtheit der Register wird auch als Ausleseregister bezeichnet. In dem Ausleseregister findet sich also ein Ausgabewert für den diskreten Signalwert am Ausgang jedes Verzögerungswerts, der zu dem jeweiligen Systemtakt ausgelesen wird und dann vorzugsweise als digital verarbeitbarer Wert zur Verfügung steht, ggf. durch Auslesen über einen Encoder.

Erfindungsgemäß wird aus einer durch die Gesamtheit der Register beim Auslesen erzeugten Signalwert-Folge ein numerischer Wert erzeugt, der den Zeitpunkt des Eintreffens des Signals an der Messvorrichtung anzeigt. Dies beruht darauf, dass die Anordnung der Register in der Gesamtheit der Register (d.h. dem Ausleseregister) der Reihenfolge der in Reihe angeordneten Verzögerungselemente entspricht. Dadurch korreliert die Signalwert-Folge mit der durch die Verzögerungselemente in der Verzögerungsschaltung hervorgerufene Verzögerung des Pegelwechsels in der Verzögerungsschaltung. Die Position des Pegelwechsels in der Verzögerungsschaltung, die einer Position des Pegelwechsels in der Signalwert-Folge entspricht, ist daher ein Maß für den Zeitpunkt des Eintreffens des Signals an der Messvorrichtung relativ zu dem Systemtakt. Dies wird später noch genauer erläutert.

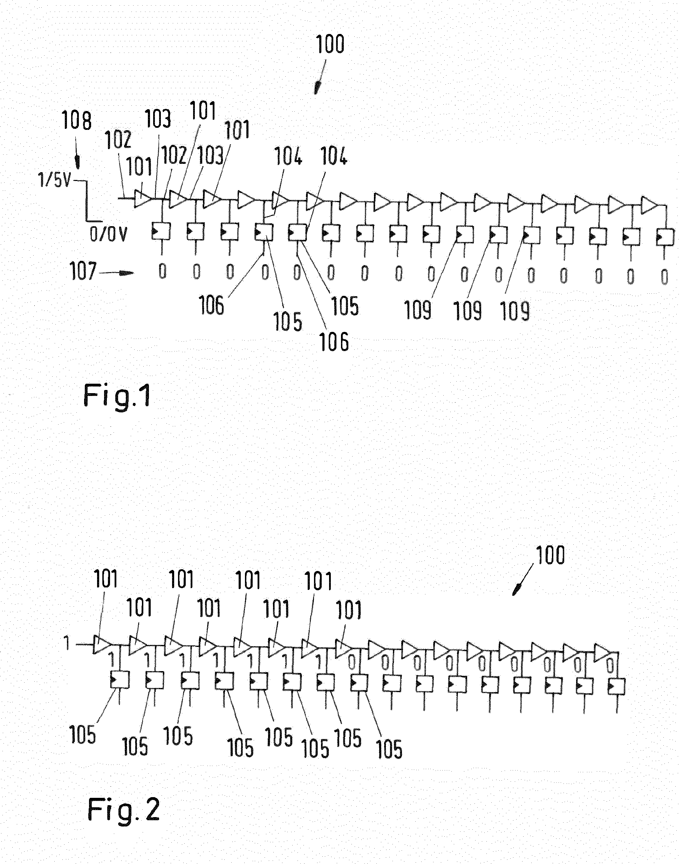

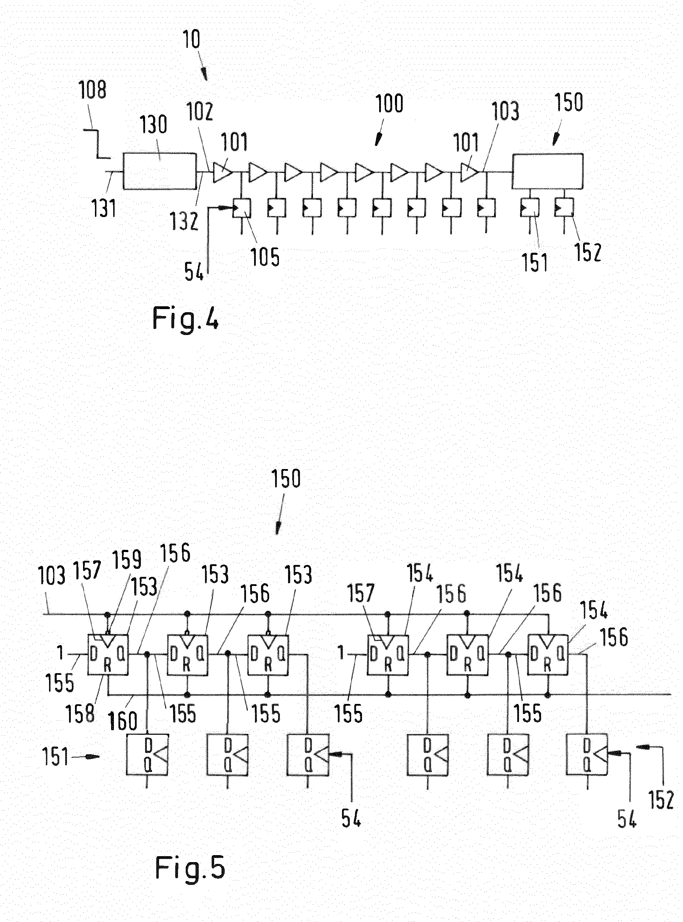

Eine solche Anordnung wird auch als Tapped Delay Line (TDL) bezeichnet und ist im Stand der Technik grundsätzlich bekannt. Die Funktionsweise einer solchen Verzögerungsschaltung wird nachfolgend anhand eines typischen Beispiels mit Bezug auf Figur 1 erläutert. Sämtliche der nachfolgend beschriebenen Merkmale können auch bei der vorliegenden Erfindung jeweils einzeln oder in beliebiger Kombination verwirklicht sein. Die erfindungsgemäßen Time-to-Digital-Konverter 10, 20, wie sie später in den Figuren 4 ff beschrieben werden, arbeiten mit diesem hier erläuterten Prinzip.

Figur 1 zeigt schematisch die Verzögerungsschaltung 100 eines einen Time-to-Digital-Konverter, der als Tapped-Delay-Line ausgebildet ist.

Auch der erfindungsgemäße Time-to-Digital-Konverter weist eine solche Verzögerungsschaltung 100 auf, die aus einer Vielzahl von in Reihe geschalteten

Verzögerungselementen 101 gebildet ist, von denen in Figur 1 sechzehn Verzögerungselemente 101 dargestellt sind. Jedes der Verzögerungselemente 101 weist einen Eingang 102 und einen Ausgang 103 auf, wobei der Ausgang 103 eines der Verzögerungselemente 101 jeweils mit dem Eingang 102 des nachfolgenden Verzögerungselements 101 verbunden ist. Der Übersichtlichkeit halber sind nicht alle darstellten Elemente mit Bezugszeichen versehen.

Der Ausgang 103 jedes Verzögerungselements 101 ist mit dem Eingang 104 eines Registers 105 verbunden. In dem Register 105 gespeicherte Signalwerte, in dem dargestellten Beispiel die Signalwerte "0" für jedes Register 105, werden über einen Ausgang 106 des Registers 105 als Signalwerte ausgelesen.

Bspw. durch ein auslösendes Ereignis wird ein Signal 108 erzeugt, dessen Eintreffen an dem Time-to-Digital-Konverter bestimmt werden soll, und in die Reihe der Verzögerungselemente 101 eingespeist. Dieses Signal 108 kann bspw. den Übergang von einem ersten Signalwert "0" auf zweiten einen Signalwert "1" im Sinne eines Pegelwechsels sein. Die Begriffe Signal und Pegelwechsel werden insoweit in diesem Text auch synonym verwendet.

Dazu wird an dem Eingang 102 des ersten (in der Darstellung linken) Verzögerungselements 101 ausgehend von einem ersten Pegel, der einem inaktiven Zustand entspricht und in dem Beispiel durch 0 V widergegeben ist, auf einen zweiten Pegel, der einem aktiven Zustand entspricht und in dem Beispiel durch 5 V wiedergegeben ist, umgeschaltet.

Der zu beobachtende Signalverkauf wird also von dem inaktiven Zustand "0" bzw. 0 V auf einen aktiven Zustand "1" bzw. 5 V umgeschaltet. Das zeitliche Auftreten dieses Pegelwechsels (Signals) wird durch die Verzögerungsschaltung 100 (Tapped Delay Line des Time-to-Digital-Konverters) gemessen.

In einem Initialzustand der Tapped Delay Line 100 hat jedes Verzögerungselement 101 den gleichen Pegel am Ausgang 103, bspw. den in Figur 1 dargestellten Pegel 0 V, der durch das Register 105 ausgelesen und beim Auslesen am Ausgang 106 des Registers 105 ausgegeben wird. Dieser Pegel wird mindestens so lange beibehalten, wie das zu messende Signal den inaktiven Pegel 0 V beibehält, d.h. das auslösende Ereignis nicht eintritt. In diesem Text wird zur Vereinfachung nicht strikt zwischen einem diskreten analogen Spannungswert (in dem Beispiel hier 0 V respektive 5 V) und einem diskreten digitalen Signalwert (in dem Beispiel hier den Binärwerten "0" und "1") unterschieden. Für beide werden die Begriffe Signalwert "0" und Signalwert "1" als erster und zweiter diskreter Signalwert verwendet. Die konkrete Umsetzung als analoger oder digitaler Signalwert bei einzelnen Bauelemente liegt im Griffbereich des Fachmanns.

Während der Zeit bis zum Eintreffen des Signals liegt also dauerhaft der Signalwert "0" (inaktiver Pegel) an dem Eingang 102 des ersten Verzögerungselements 101 an. Dieser Signalwert wird (zumindest bei einer Änderung auf diesen Signalwert) über den Ausgang nach der inhärenten Verzögerungszeit an das nächste Verzögerungselement ausgegeben, usw. Dadurch werden alle Verzögerungselemente 101 auf den inaktiven Pegel gestellt (bspw. nach dem Messen des vorherigen Signals 108) und gehalten, solange das nächste Signal 108 nicht eintrifft. Dies ist der Initialzustand der Verzögerungselemente 101. Technisch kann dies so sein, dass an dem Eingang 102 und Ausgang 103 aller Verzögerungselemente dauerhaft der Signalwert "0" anliegt, der sich nicht ändert. Insofern muss in diesem Zustand technischen Sinne keine Übertragung von Signalwerten stattfinden. Weil der an dem Eingang des ersten Verzögerungselements 101 anliegende Signalwert aber in allen Verzögerungselement gleich eingestellt ist und bleibt, wird dies im Rahmen der Erfindung auch als "Übertragen" des Signalwerts "0" auf die nachfolgenden Verzögerungselemente 101 bezeichnet, im Sinne eines Herstellens und Aufrechterhaltens eines definierten Zustands, hier des Init-Zustands.

In dem dargestellten Beispiel der Tapped Delay Line 100 wird das Signal 108 (d.h. der Pegelwechsel), bspw. ausgelöst durch ein externes auslösendes Ereignis, an einem Eingang 102 des ersten Verzögerungselements 101 eingespeist, wie es auch einer Ausführungsform der vorliegenden Erfindung entspricht. Grundsätzlich kann das Signal 108 aber auch an dem Eingang jedes anderen Verzögerungselements 101 eingespeist werden. Die nachstehende Erläuterung gilt dann entsprechend für die diesem Verzögerungselement 1010 nachfolgenden Verzögerungselemente 101.

Das Signal 108 wird also durch einen Signalwertwechsel von dem diskreten Signalwert "0" auf den diskreten Signalwert "1", d.h. einen Pegelwechsel, in die Verzögerungsschaltung eingespeist. Sobald der durch das auslösende Ereignis hervorgerufene und zu messende Pegelwechsel, d.h. das Signal 108, die Verzögerungsschaltung bzw. die Tapped-Delay-Line 100 den Eingang 102 des ersten Verzögerungselements erreicht, liegt an dem Eingang 102 des ersten Verzögerungselements 101 (allgemeiner des Verzögerungselements, in das das Signal 108 eingespeist wird) der diskrete Signalwert "1" an.

Nach der dem ersten Verzögerungselement 101 inhärenten Verzögerungszeit wird der Signalwert "1" an dem Ausgang 103 des ersten Verzögerungselements 101 ausgegeben und damit am Eingang 102 des zweiten (d.h. nachfolgenden) Verzögerungselements 101 angelegt. Auch das zweite Verzögerungselement 101 gibt dann den an seinem Eingang 102 anliegenden Signalwert "1" nach der inhärenten Verzögerungszeit an seinen Ausgang 103 wieder aus.

Auf diese Weise durchwandert der Pegelwechsel (respektive das Signal 108) die gesamte Verzögerungsschaltung 100 bis zu dem letzten Verzögerungselement 101.

Solange der Signalwert 108 am Eingang 102 des ersten Verzögerungselements 101, in das das Signal 108 eingespeist wird, nach dem Einspeisen nicht verändert wird, werden nach und nach alle in Reihe geschalteten Verzögerungselemente 101 mit diesem Signalwert, in dem Beispiel der Figur 1 also mit dem Signalwert "1", aufgefüllt. In einer möglichen Ausführungsform, wie sie hier beschrieben ist, wird nach dem auslösenden Ereignis der Aktiv-Pegel (Signalwert "1") in diesem Sinne am Eingang 102 des ersten Verzögerungselements 101 konstant gehalten, bis das Signal 108 respektive der Pegelwechsel die komplette Verzögerungsschaltung 100 durchlaufen hat. Danach nimmt es wieder den Inaktiv-Pegel (Signalwert "0") ein.

Dies ist in Figur 2 in einem Zustand veranschaulicht, in dem der an dem Eingang 102 des ersten Verzögerungselements 101 der Fig. 1 mit der jeweils inhärenten Verzögerungszeit der Verzögerungselemente 101 bis zu dem siebten Verzögerungselement 101 durch die Verzögerungsschaltung 100 gewandert ist. Am Ausgang 102 jedes der ersten sieben Verzögerungselemente 101 liegt der Signalwert "1" an. Dieser Signalwert "1" liegt damit auch am Eingang 104 der ersten sieben Register 105 an, die mit dem Ausgang103 jeweils eines der ersten sieben Verzögerungselemente 101 verbunden ist.

An dem Ausgang des achten Verzögerungselements 101 (in der Darstellung der Figur 2 das letzte mit dem Bezugszeichen 101) liegt der Signalwert "1" nur an dem Eingang 102, aber noch nicht an dem Ausgang 103 an. Dies bedeutet, dass Figur 2 eine Momentaufnahme des Zustands der Verzögerungsschaltung 100 während der inhärenten Verzögerung des achten Verzögerungselements 101 ist, während der der Pegelwechsel respektive das Signal 108 von dem Eingang 102 auf den Ausgang 103 dieses Verzögerungselements ausgegeben wird.

Es ist nun vorgesehen, dass der an dem Eingang 104 jedes der Register 105 anliegende diskrete Signalwert in einem Systemtakt gespeichert und über den Ausgang 106 jedes Registers 105 ausgegeben wird (vgl. auch Figur 1).

Wenn veranlasst durch den Systemtakt gerade der in Figur 2 dargestellte Zustand der Verzögerungsschaltung 100 in den Registern 105 gespeichert wird, wird für die ersten sieben Verzögerungselemente 101 nach der Einspeisung des Signals 108 der Signalwert "1" gespeichert, und für der restlichen Verzögerungselemente 101 der initiale Signalwert "0".

An den Ausgängen 106 aller Register 105 wird (in der Darstellung der Figur 2 von links nach rechts) also die Folge der Signalwerte
1111111000000000
als Signalwert-Folge 107 ausgelesen. In Figur 1 mit dem Initialzustand der Verzögerungselemente 101 besteht die Signalwert-Folge 107 dagegen nur aus den Signalwerten "0".

Entsprechend wird die Gesamtheit aller Register 105 auch als Ausleseregister bezeichnet, das - ggf. mittels eines nicht dargestellten Encoders - aus der Folge von Signalwerten bspw. ein Bit-Muster formt (im Falle binärer Signalwerte). Ein solcher Encoder kann erfindungsgemäß durch Schaltungsteile gebildet sein, die die (auch Thermometer-Code genannte) Signalwert-Folge 107 in einem kompakteren numerischen Wert umwandeln, bspw. mittels einer Analog-zu-Digital-Konversion. Entsprechende Encoder sind in der Fachwelt bekannt und müssen hier nicht gesondert beschrieben werden, auch wenn sie zu der Erfindung dazugehören und Teil der Erfindung sein können.

Im Falle ternärer oder anderer Signalwerte wird eine entsprechende Signalwert-Folge geformt und vorzugsweise durch einen Encoder entsprechend verarbeitet.

Jeder Signalwert "1" bedeutet, dass das mit dem auslösenden Ereignis eingespeiste Signal 108 mit der inhärenten Verzögerungszeit eines der Verzögerungselemente 101 durch die Verzögerungsschaltung 100 durchgelaufen ist, bevor das Ausleseregister (d.h. die Gesamtheit aller Register 105) ausgelesen wurde. In dem dargestellten Beispiel hat das Signal 108 bis zur Auslesung sieben Verzögerungselemente 101 durchwandert. Dafür hat es die siebenfache inhärente Verzögerungszeit benötigt. Diese Zeitspanne gibt also an, wieviel Zeit zwischen dem auslösenden Ereignis und der durch den Systemtakt vorgegeben Auslesung verstrichen ist. Daraus lässt sich der Zeitpunkt des Eintreffens des (bspw. durch das auslösende Ereignis ausgelösten) Signals 108 an der Messvorrichtung, d.h. dem Time-to-Digital-Konverter mit der Verzögerungsschaltung 100, relativ zu dem aktuellen Systemtakt bestimmen.

Allgemeiner ausgedrückt wird sich das Signal 108 (Pegelwechsel) mit fortschreitender Zeit entlang der Verzögerungsschaltung 100 fortbewegen. Nach einer gewissen Zeit lässt sich beobachten, dass die ersten N Verzögerungselemente 101 bereits den Pegelwechsel vollzogen haben und den Signalwert "1" aufweisen. In einer realen Schaltung sind dahinter ein oder mehrere Verzögerungselemente 101 im Schaltvorgang (inhärenten Verzögerungszeit) begriffen. In Figur 2 ist dies das achte Verzögerungselement 101. Für diese im Schaltvorgang befindlichen Verzögerungselemente 101 ist es zufällig, ob zum Zeitpunkt der Auslesung, d.h. dem bei dem aktuellen Systemtakt, der Schaltvorgang bereits vollzogen ist und der Pegelwechsel in dem zugehörigen Register 105 bereist erkennbar ist. Die restlichen Verzögerungselemente 101 bis zum Ende der Verzögerungsschaltung haben noch den Initial-Pegel an ihrem Ausgang, d.h. im dargestellten Beispiel den Signalwert "0".

Das Bit-Muster (die Signalwert-Folge 107) an den Ausgängen 106 der Register 105 entspricht in erster Näherung einem sogenannten Thermometer-Code. Der Thermometer-Code ist umso "höher" (in dem Beispiel repräsentiert durch eine größere Anzahl von Signalwerten "1" in dem Bit-Muster), je früher der zu messende Pegelwechsel vor dem definierten Systemtakt eingetroffen ist.

Das Speichern der Signalwerte in den Registern 105 und deren Auslesen in dem Systemtakt kann in einer technischen Ausführung wie folgt realisiert sein.

Wie Figur 1 verdeutlicht, kann ein bzw. jedes Register 105 neben dem Eingang 104 und dem Ausgang 106 erfindungsgemäß auch einen Takteingang 109 aufweisen, der in den Figuren durch ein schwarzes Dreieck dargestellt ist.

Das Register 105 kann nun dazu eingerichtet sein, dass das Register 105 beim Auftreten eines Taktsignals (im Sinne eines definierten Pegelwechsels) am Takteingang 109 den Pegel (Signalwert) am Eingang 104 des Registers 105 speichert und am Ausgang 106 des Registers 105 ausgibt. Ein solches Taktsignal, das in einer bestimmten Taktperiode auftritt, wird in diesem Text auch als Systemtakt bezeichnet. Vorzugsweise hält das Register 105 den gespeicherten und ausgegebenen Pegel (Signalwert) am Ausgang 106 bis zum erneuten Eintreffen eines neuen Taktsignals am Takteingang 109 konstant, woraufhin der dann am Eingang 104 des Registers 105 anliegende Pegel (Signalwert) gespeichert und am Ausgang 106 des Registers 105 ausgegeben wird.

Das Taktsignal (Systemtakt) im Sinne eines definierten Pegelwechsels kann bspw. die steigende oder fallende Flanke eines Taktpulses, also eine definierte Taktflanke, sein. Mit jeder nächstfolgenden definierten Taktflanke wird der zu diesem Zeitpunkt vorherrschende Zustand der Ausgänge 103 der Verzögerungselemente 101, d.h. die dort anliegenden Signalwerte, in das Ausleseregister, d.h. jedes der Register 105, eingeschrieben.

Prinzipiell ist es so, dass das durch das auslösende Ereignis ausgelöste Signal 108 (d.h. der Pegelwechsel in dem Eingang 102 des mit diesem Signal beaufschlagten Verzögerungselements 101), dessen Zeitpunkt bestimmt werden soll, asynchron zum Taktsignal an der Messvorrichtung eintreffen kann, d.h. zu jedem beliebigen Zeitpunkt zwischen den definierten Taktflanken. Der Thermometer-Code kann also dazu verwendet werden, den Zeitpunkt des zu messenden Signals 108 (Pegelwechsels) innerhalb einer Taktperiode mit höherer zeitlicher Auflösung als dem Systemtakt zu bestimmen.

In dem hier beschriebenen Beispiel ist das Signal 108 durch einen Wechsel des Signalwerts von "0" auf "1", also eine steigende Flanke in dem Signalverlauf des am Eingang 102 des ersten Verzögerungselements 101, definiert. Das Rückstellen des Signalwerts auf den Signalwert "0" definiert dann eine fallende Flanke in dem Signalverlauf. Ein solches Rückstellen kann bspw. immer nach einem Systemtakt oder zu anderen geeignet definierten Zeitpunkten erfolgen.

Nach dem Auftreten der fallenden Flanke in dem Signalverlauf wandert auch diese fallende Flanke wieder vollständig durch die komplette Verzögerungsschaltung, d.h. mit anderen Worten bezogen auf das konkrete Beispiel: der Signalwert "0" wird mit der dem Verzögerungselement 101 inhärenten Verzögerungszeit sukzessive von dem Eingang 102 eines Verzögerungselements 101 über dessen Ausgang 103 an den Eingang 102 des jeweils nächsten Verzögerungselements 101 übertragen.

Dieser Signalwert "0" (bzw. mit anderen Worten der Inaktiv-Pegel) am Eingang des ersten Verzögerungselements 101 (zumindest im Sinne des Einspeisepunkts; in anderen Ausgestaltungen der Erfindung muss der Einspeisepunkt nicht zwangsläufig mit dem räumlich ersten Verzögerungselement 101 der Verzögerungsschaltung 100 zusammenfallen) wird beibehalten, bis die Verzögerungsschaltung 100 wieder den Initial-Zustand eingenommen hat, d.h. in dem hier dargestellten Beispiel alle Verzögerungselemente 101 den Signalwert "0" aufweisen. Erst danach kann ein neues, bspw. durch ein neues auslösendes Ereignis ausgelöstes Signal 108 (also ein erneuter Pegelwechsel mit einer positiven Flanke) zeitlich relativ zu dem Systemtakt bestimmt werden. Dieser zeitliche Abstand von messbaren Pegelwechseln wird Totzeit genannt.

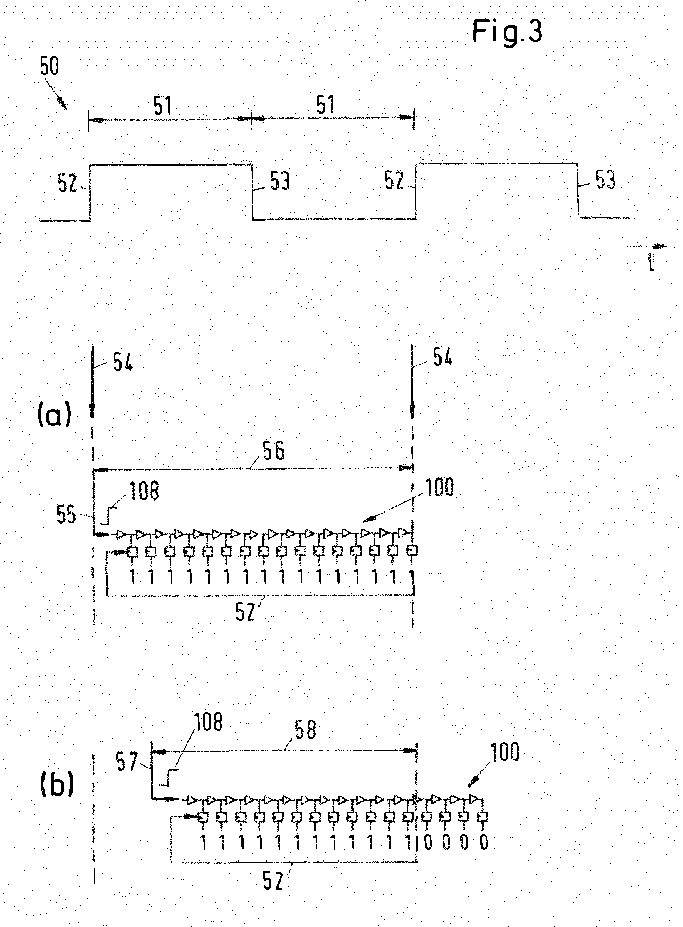

In einer bevorzugten Ausführung auch der Erfindung kann der Systemtakt durch ein Taktsignal 50 an dem Takteingang 109 der Register 105 realisiert werden, wie es als Signalverlauf in Figur 3 dargestellt ist. Das Taktsignal 50 weist in einem konstanten zeitlichen Abstand 51 Pegelwechsel 52, 53 auf, und zwar im Wechsel eine positive Taktflanke 52 und ein negative Taktflanke 53. Nachfolgend wird beispielhaft angenommen, dass der Systemtakt 54 durch die positive Taktflanke 52 des Signalverlaufs des Taktsignals 50 bestimmt wird.

Jeweils bei dem Auftreten eines Taktsignals 50 (präzise dem Auftreten der positiven Taktflanke 52 des Taktsignals, d.h. dem Systemtakt 54) werden die Register 105 an ihren Takteingängen 109 getaktet. Dies wird nachfolgend auch als Takten des Ausleseregisters bezeichnet. Hierdurch wird der jeweils am Eingang 104 des Registers 105 anliegende Signalwert gespeichert und am Ausgang 106 des Registers ausgegeben.

Wenn zwischen zwei aufeinander folgenden Taktsignalen 50, d.h. im Systemtakt 54, der am Eingang 104 des Register 105 anliegende Signalwert unverändert geblieben ist, wird auch der unveränderte Signalwert übernommen. Gleiches gilt natürlich bei einer Änderung des Signalwerts am Eingang 104 des Registers 105. Somit enthält das Ausleseregister (als Gesamtheit aller Register 105) einen zum Zeitpunkt des Taktsignals 50 (d.h. der positiven Taktflanke 52 im Systemtakt 54) den jeweils aktuellen Status der gesamten Verzögerungsschaltung 100.

Der Systemtakt 54 ist in Figur 3 als jeweils unter der steigenden Flanke 52 als nach unten weisende Pfeile dargestellt, die in eine gestrichelte Linie übergehen. Eine Taktperiode ist die Zeitdauer zwischen den den Systemtakt 54 symbolisierenden Pfeilen.

Sofern alle Register 105 den Signalwert "0" (bspw. allgemeiner den Inaktiv-Pegel) aufweisen, ist in diesem Systemtakt kein auslösendes Ereignis aufgetreten. Wenn dagegen ein Signal 108 in die Verzögerungsschaltung 100 eingespeist wurde, hat dieses Signal 108 in der vorbeschriebenen Weise das Hochzählen des Thermometer-Codes (Signalwert-Folge 107) ausgelöst. Je mehr aktive Signalwerte bzw. Pegel, d.h. in dem Beispiel also Signalwerte "1", in dem Thermometercode enthalten sind, desto früher - bezogen auf des nächste Taktsignal 50 (bzw. in dem Beispiel auf die steigende Taktflanke 52) - hat das auslösende Ereignis stattgefunden.

In dem unter (a) dargestellten Fall der Figur 3 erfolgt Eintreffen 55 eines Signals 108 an der Messvorrichtung, dargestellt durch einen abgewinkelten Pfeil, mit oder unmittelbar nach einem Systemtakt 54. Unmittelbar nach dem Systemtakt 54 bedeutet insbesondere nach einer Zeitspanne, die etwa einer oder zwei inhärenten Verzögerungszeiten der Verzögerungselemente 11 entspricht.

Nach Eintreffen 55 des Signals 108 wird es in das erste Verzögerungselement 101 der Verzögerungsschaltung 100 eingespeist. Es beginnt das Hochzählen des Thermometer-Codes mit der inhärenten Verzögerungszeit der Verzögerungselemente 101. Um den Zeitpunkt des auslösenden Ereignisses 55 relativ zu dem nachfolgenden Taktsignal 50, respektive dem nachfolgenden Systemtakt 54, ermitteln zu können, muss der Thermometer-Code also mindestens die gesamte Taktperiode zwischen den aufeinander folgenden Systemtakten 54 abdecken, wie durch die in Figur 3 (a) eingeblendete Verzögerungsschaltung 100 symbolisiert.

Die Auslesung des Ausleseregisters erfolgt dann mit dem dem auslösenden Ereignis 55 folgenden Systemtakt 54 (in Figur 3 also dem rechts dargestellten Systemtakt 54). Dies ist durch die Verbindungslinie 55 von dem Systemtakt zum dem Takteingang 109 des ersten der Register 105 symbolisiert.

In diesem Fall (a) hat das Signal 108 bis zur Auslesung des Ausleseregisters 108 sämtliche Verzögerungselemente 101 der Verzögerungsschaltung 100 durchlaufen. Der Zeitpunkt des auslösenden Ereignisses 55, das das Signal 108 ausgelöst hat, lag also eine Zeitspanne 56 vor dem das Auslesen anstoßenden Systemtakt 54. Diese Zeitspanne 56 ergibt sich aus der Summe der inhärenten Verzögerungszeiten aller Verzögerungselemente bzw. der Anzahl der (durchlaufenen, in diesem Fall aller) Verzögerungselemente multipliziert mit einer mittleren inhärenten Verzögerungszeit. In diesem Fall (a) entspricht die Zeitspanne 56 der Gesamtverzögerungszeit der Verzögerungsschaltung 100 und der Taktperiode.

Aus diesem Fall (a) ergibt sich, dass bei einer technischen Realisierung herkömmlicher Tapped Delay Lines (TDL) nach dem Stand der Technik die Bedingung eingehalten werden, dass die Taktperiode des Taktsignals 50 (d.h. der Systemtakt 54) kürzer als oder maximal gleichlang wie die Gesamtverzögerungszeit der Verzögerungsschaltung 100 sind muss. Andernfalls wäre es sonst möglich, dass das Signal 108 (Pegelwechsel) die gesamte Verzögerungsschaltung 100 durchlaufen hat, bevor der zeitlich nachfolgende Systemtakt 54 auftritt. In diesem Fall würden die Ausgänge 106 der Register 105 (zumindest ab diesem Zeitpunkt) alle denselben Signalwert (Pegel) aufweise. Eine Aussage über den Zeitpunkt des Eintreffens des Signals 108 an der Messvorrichtung könnte dann nicht mehr getroffen werden.

Zur Verdeutlichung soll noch ein zweiter Fall (b) beschrieben werden. In diesem Fall (b) soll ein das Eintreffen 57 des Signals 108 eine Zeitspanne 58 vor dem nächsten Systemtakt 54 auftreten, Entsprechend wird das Signal 108 zu diesem Zeitpunkt in das erste Verzögerungselement 101 der Verzögerungsschaltung 100 eingespeist. Das Signal 108 (d.h. der Pegelwechsel) durchläuft anschließend die Verzögerungsschaltung 100 und erreicht bis zum Auslesen des Ausleseregisters zum Zeitpunkt des folgenden Systemtakts 54 das 12. Verzögerungselement 101 durchlaufen. An den zugehörigen Registern 105 liegt entsprechend der Signalwert "1" an, der mit dem Systemtakt 54 auch ausgelesenen wird. Die restlichen vier Verzögerungselemente 101 weisen noch den initialen Signalwert "0" (Init-Pegel) auf.

Bisher wurde nur beschrieben, wie der Zeitpunkt des Eintreffens des Signals 108 an der Messvorrichtung, d.h. der Zeitpunkt des Einspeisens des Signals 108 in eines der Verzögerungselemente 101 der Verzögerungsschaltung 100, relativ zu dem jeweils folgenden Systemtakt 54 bestimmt wird. Dies erlaubt noch keine absolute Zeitbestimmung in einem übergeordneten System, in dem ggf. auch mehrere Detektoren betrieben und deren Signale korreliert werden sollen.

Hierzu kann erfindungsgemäß das Taktsignal 50 in einem ausgezeichneten System, bspw. dem übergeordneten System mehrerer Detektoren, erzeugt werden. Weiterhin ist ein Zähler mit hinreichend großem Zählbereich vorgesehen, dessen Zählerstand als digitaler Wert ausgegeben wird. Dieser Zählerstand beim wird Auftreten eines definierten Pegelwechsels in dem Taktsignal 50, bspw. jeder ansteigenden Flanke 52 und damit bei jedem Systemtakt 54, um 1 erhöht, zusammen mit den Auslesen des Ausleseregisters. Der ausgelesenen Signalwert-Folge 107, respektive dem ausgelesenen Thermometer-Code, wird auch der jeweilige Zählerstand zugeordnet, bspw. indem dieser zusammen mit dem Bit-Muster abgespeichert wird. Hierdurch lässt sich die Systemzeit auch absolut in der Zeit durch das Taktsignal und den Zähler definierten Zeit bestimmen. Mit anderen Worte ist der (in dem Beispiel steigenden) Taktflanke 52 (d.h. dem Systemtakt 54) zudem der Zählerstand des Zählers (als lokale Uhrzeit) zugeordnet. Thermometer-Code und Zählerstand sind somit die Messergebnisse, die den Zeitpunkt des Eintreffens des zu messenden Signals 108 (Pegelwechsels) bestimmen.

In der Praxis zeigt sich, dass bei bekannten, als solche Tapped-Delay-Line (TDL) ausgebildeten Time-to-Digital-Konvertern die Hersteller die Verzögerungselemente 101 optimiert haben und kurze inhärente Verzögerungszeiten erreichen. Die erreichbaren Taktraten des Systemtakts sind - im Vergleich dazu - allerdings relativ niedrig. Daraus ergibt sich die Notwendigkeit, sehr lange Verzögerungsschaltungen 100 zu bilden, damit ein eingespeistes Signal 108 (Pegelwechsel) zwischen den aufeinander folgenden Systemtakten nicht vor dem nächsten Systemtakt 54 aus der Verzögerungsschaltung 101 ausläuft.

So kommt es in Anwendungen vor, dass eine Tapped-Delay-Line mehrere hundert hintereinander in Reihe geschaltete Verzögerungselemente aufweist. Das hat einen hohen Schaltungsaufwand sowohl für die Tapped-Delay-Line als auch einen Encoder zur Folge, in dem die ausgelesenen Signalwerte (Pegel) der jeweils einem der Verzögerungselemente zugeordneten Register verarbeitet, meist digitalisiert, werden.

Gerade in großphysikalischen Streuexperimenten ist die Zeitmessung eine der ganz wesentlichen (dominanten) Messaufgaben für Teilchen-Detektoren. Oft muss dabei für viele zehntausend Signale (Kanäle) gleichzeitig eine Zeitmessung erfolgen. Der geräte-technische Aufwand dafür ist enorm, was in mehrfacher Hinsicht ein Problem darstellt. Zum einen stellt dies ein Platzproblem am Messort dar, da jeder Messkanal eine elektronische Einheit mit einem gewissen Platzbedarf darstellt, bspw. als ein Element eines FPGA-Moduls. Da jedes elektronische Bauteil im Betrieb auch Wärme erzeugt, kann es auch zu einer starken Erwärmung der Messelektronik kommen, was entsprechende Messpausen nach nicht zieht oder eine aktive Kühlung der Messelektronik erfordert. Beides ist aufwendig und in der Anwendung nachteilig. Letztlich ist auch noch der finanzielle Aufwand für die Messelektronisch zu erwähnen.

Unter Beibehaltung der erreichten zeitlichen Auflösung wäre es zur Lösung dieses Problems eigentlich naheliegend, die Taktrate des Systemtakts zu erhöhen, mit der die an dem Ausgang der Verzögerungselemente ausgegebenen Signalwerte (Pegel) in dem Ausleseregister gespeichert und ausgelesen werden. Bei einer verkürzten Taktperiode würde sich auch die benötigte Gesamtverzögerungszeit der Tapped Delay Line verkürzen, was eine kürzere Tapped Delay Line (respektive eine Verzögerungsschaltung mit weniger Verzögerungselementen) erlauben würde. Bei den als Verzögerungselementen bevorzugt verwendeten FPGAs (Field Programmable Gate Array), die später noch näher erläutert werden, lässt sich der Systemtakt allerdings nicht beliebig erhöhen. Eine derartige Lösung lässt sich also nur in engen Grenzen anwenden, und würde das zuvor geschilderte Problem nicht wirklich lösen.

Aufgabe der Erfindung ist es vor diesem Hintergrund, eine Time-to-Digital-Konversion vorzuschlagen, die eine Zeitmessung mit geringerem apparativen Aufwand und ohne Verringerung der zeitlichen Auflösung ermöglicht.

Zur Lösung der Aufgabe wird ein Verfahren zur Time-to-Digital-Konversion der vorstehend beschriebenen Art nach Anspruch 1 vorgeschlagen, dass das eintreffende Signal als eine (vorzugsweise zeitlich genau festgelegte) Sequenz von (mindestens zwei) Pegelwechseln. insbesondere mittels eine Pulsgenerators, in die Verzögerungsschaltung einspeist und jeder Pegelwechsel am Ausgang des letzten Verzögerungselements (in Sinne des letzten Verzögerungselements, durch das der Pegelwechsel in der Reihe der Verzögerungselemente durchläuft) in einem Austritts-Zähler gezählt wird.

Das Zählen der mit dem Signal (in zeitlicher Sequenz) in die Verzögerungsschaltung eingespeisten Pegelwechsel beim Austritt aus der Verzögerungsschaltung ermöglicht es, die Anzahl der in Reihe geschalteten Verzögerungselemente zu verkleinern und damit die Tapped-Delay-Line zu verkürzen. Die Gesamtverzögerungszeit der in Reihe geschalteten Verzögerungselemente kann dann erfindungsgemäß zeitlich kleiner (kürzer) als die Taktperiode des Systemtakts sein, weil das eingespeiste Signal, dessen Eintreffen an der Messvorrichtung gemessen werden soll, als Sequenz von Pegelwechseln sozusagen mehrfach (grundsätzlich sogar beliebig oft) durch die Verzögerungsschaltung durchläuft und jeder Durchgang gezählt wird. Somit entfällt die Notwendigkeit, die Gesamtverzögerungszeit der Hardware-Verzögerungsschaltung länger als die Taktperiode zu gestalten, da jeder Pegelwechsel, der die Verzögerungsschaltung komplett durchlaufen hat, nicht verschwindet, sondern vom Austritts-Zähler erfasst wird. Aufgrund der zeitlich festgelegten Sequenz, mit der die Pegelwechsel - ausgelöst durch das erzeugte Signal - in die Verzögerungsschaltung eingespeist werden, ergibt sich auch ein genaue zeitliche Lage der Pegelwechsel zueinander, so dass der Zeitpunkt des Eintreffens des (die Sequenz der Pegelwechsel auslösenden) Signal auch dann genau bestimmt werden, wenn die Gesamtverzögerungszeit der in Reihe geschalteten Verzögerungselemente (entsprechend der Summe ihrer inhärenten Verzögerungszeiten) kleiner ist als die Zeitspanne zwischen dem Eintreffen des Signals und dem nächsten Systemtakt.

Die Bedingung für eine korrekte Messung besteht nun lediglich darin, dass die Sequenz von eingespeisten Pegelwechseln mindestens für die Dauer einer Taktperiode aufrechterhalten wird. Dies kann einfach entsprechend den jeweiligen Gegebenheiten festgelegt werden. Das Erzeugen der Sequenz von Pegelwechseln kann durch einen Pulsgenerator erfolgen. Damit können grundsätzlich beliebig lange Messzeiten realisiert werden, so dass ein Anpassen an die Taktperiode eines jeweiligen Systemtakts besonders einfach ist. Dies macht das erfindungsgemäß vorgeschlagene Verfahren und einen einsprechend eingerichteten Time-to-Digital-Konverter besonders flexibel.

Dadurch kann die Verzögerungsschaltung, insbesondere eine Tapped-Delay-Line, wesentlich verkürzt werden. Dies verringert den schaltungstechnischen Aufwand nicht nur für die Verzögerungsschaltung mit Verzögerungselementen und jeweils zugeordneten Registern, sondern (sogar in erster Linie) auch für einen den Registern, die zusammen das Ausleseregister bilden, nachgeschalteten Encoder, der eine entsprechend kürzere Signalwert-Folge zu verarbeiten hat.

Eine besonders bevorzugte Ausführungsform der Erfindung sieht vor, dass die Sequenz von Pegelwechseln als eine Sequenz von aufeinander folgenden positiven und negativen Flanken eingespeist wird. Abwechselnde positive und negative Flanken in den Pegelwechseln lassen sich sehr einfach detektieren und entsprechend schnell verarbeiten.

Eine bevorzugte technische Realisierung sieht vor, digitale Schaltungen mit binären Signalen zu verwenden. In diesem Fall wird ein binäres Signal in die Verzögerungsschaltung eingespeist, dessen Signalverlauf nur Pegelwechsel zwischen den diskreten Signalwerten "0" und "1" annehmen kann. Dann sind die als Sequenz eingespeisten und entsprechend aus der Verzögerungsschaltung austretenden Pegelwechsel notwendigerweise abwechselnd steigende und fallende Flanken im binären Signalverlauf zwischen den Signalwerten bzw. Pegeln "0" und "1".

Es ist erfindungsgemäß besonders vorteilhaft, wenn jeweils mindestens ein separater Austritts-Zähler für verschiedene (ggf. sogar jeden verschiedenen) Pegelwechsel vorgesehen ist. Als verschiedener Pegelwechsel wird insbesondere ein Pegelwechsel angesehen, der ausgehend von einem bestimmten Pegel (Signalwert) auf einen anderen bestimmten Pegel (Signalwert) umschaltet. Bei einem binären Signal sind dies entsprechend zwei Austritts-Zähler, nämlich ein Austritts-Zähler für fallende Flanken (Pegelwechsel von dem diskreten Signalwert "1" auf den diskreten Signalwert "0") und ein Austritts-Zähler für steigende Flanken (Pegelwechsel von dem diskreten Signalwert "0" auf den diskreten Signalwert "1").

So muss jeder Austritts-Zähler nur den Übergang auf einen diskreten Signalwert feststellen, um ein Signal mit dem entsprechenden Pegelwechsel zu zählen. Dies lässt sich gerätetechnisch besonders einfach durch Schiebregister lösen, die jeweils nur dann ansprechen, wenn ein entsprechender diskreter Signalwert an ihrem Eingang anliegt, bzw. genauer ein Wechsel auf diesen diskreten Signalwert. Schieberegister sind in der Lage, Pegelwechsel an ihrem Eingang sehr schnell zu erkennen und zu registrieren. Im Falle eines binären Signals werden erfindungsgemäß bevorzugt also zwei Schieberegister vorgesehen.

Dies ist vor dem Hintergrund wichtig, dass die minimale Länge der Verzögerungsschaltung (bspw. Tapped-Delay-Line) in einer möglichen technischen Realisierung durch die maximale Zählrate des Austritts-Zählers vorgegeben wird. Der Austritts-Zähler wird getaktet durch die aus der Verzögerungsschaltung austretenden Pegelwechsel. Durch das Festlegen eines Austritts-Zählers auf einen diskreten Signalwert wird die Erfassungsgeschwindigkeit signifikant erhöht. Dies führt zu einer höheren maximale Zählrate des Austritts-Zählers.

Bei immer wechselnden Flanken in den aufeinander folgenden Pegelwechseln aus der eingespeisten Sequenz von Pegelwechseln, wie sie bei einem binären Signal oder Signalverlauf zwangsläufig vorliegt, wird dadurch die Taktrate halbiert.

Bei einem binären Signal werden gemäß einer besonders bevorzugten Variante des erfindungsgemäßen Verfahrens daher zwei Schieberegister in dem Austritts-Zähler verwendet, wobei eines des Schieberegister für das Zählen der steigenden Flanken und das andere der Schieberegister für das Zählen der fallenden Flanken am Austritt des Schieberegisters verwendet wird. Eine besonders bevorzugte Realisierung der Schieberegister wird später noch beschrieben.

Durch die bisher beschriebenen Merkmale ist es erfindungsgemäß möglich, deutlich kürzere Verzögerungsschaltungen mit weniger in Reihe geschalteten Verzögerungselementen zu verwenden.

In einer technischen Realisierung einer Verzögerungsschaltung mit in Reihe geschalteten Verzögerungselementen, insbesondere bei den als Verzögerungselementen bevorzugt verwendeten FPGAs (Field Programmable Gate Array), sind die inhärenten Verzögerungszeiten der einzelnen Verzögerungselemente in einer Verzögerungsschaltung jedoch unterschiedlich und variieren zufällig. Je nach verwendeten Elementen können die inhärenten Verzögerungszeiten durchaus um eine Größenordnung variieren. Dies hat eine hohe Differentielle Nicht-Linearität (DNL) bei der Propagation der Pegelwechsel (Flanken im Signalverlauf, die in diesem Text häufig auch verkürzend als Signale bezeichnet sind) zur Folge, und führt somit zu einer reduzierten Messpräzision bei der Bestimmung des Zeitpunkts des Eintreffens eines Signals an der Messvorrichtung, insbesondere einem Time-to-Digital-Konverter.

Eine Möglichkeit, diesen Effekt zu reduzieren, liegt darin, die Sequenz von Pegelwechseln so in die Verzögerungsschaltung einzuspeisen, dass sich mehrere Pegelwechsel gleichzeitig in der Verzögerungsschaltung befinden und dementsprechend fortbewegen, d.h. die in Reihe geschalteten Verzögerungselemente in der beschriebenen Weise durchlaufen. Entsprechend wird im Systemtakt der Zustand der Verzögerungsschaltung, d.h. der zugehörige Signalwert am Ausgang jedes Verzögerungselements, in dem Ausleseregister gespeichert und ausgegeben. Die Signalwert-Folge (im Falle eines binären Signals eine Bit-Folge im Sinne eines Bit-Musters) enthält entsprechend mehrere Pegelwechsel, die bspw. durch aufeinander folgende positive und negative Flanken in der Signalwert-Folge in Erscheinung treten.

In einer bevorzugten Ausführung können die mehreren Pegelwechsel, d.h. mindestens zwei oder mehr Pegelwechsel, an verschiedenen Verzögerungselementen eingespeist werden. Dies kann gleichzeitig geschehen. Hierdurch wird sichergestellt, dass immer mindestens zwei Pegelwechsel in der Verzögerungsschaltung eingespeist sind. Es sind aber auch Realisierungen möglich, in denen Pegelwechsel so schnell nacheinander eingespeist werden, dass der zuerst eingespeiste Pegelwechsel aufgrund der inhärenten Verzögerungszeiten der Verzögerungselemente nur einen Teil der gesamten Verzögerungselemente durchlaufen hat, bis der nächste Pegelwechsel eingespeist wird. Auch so kann sichergestellt werden, dass immer mehrere Pegelwechsel durch die Verzögerungsschaltung durchlaufen. Auch eine Kombination der beschriebenen Möglichkeiten ist denkbar.

Die mehreren Pegelwechsel propagieren nun gleichzeitig durch die Verzögerungsschaltung, aber jeweils an verschiedenen Positionen, d.h. zu einem Zeitpunkt durch verschiedene Verzögerungselemente. Diese mehreren Pegelwechsel sind auch in der aus dem Ausleseregister ausgelesenen Signalwert-Folge identifizierbar.

Erfindungsgemäß kann gemäß einer bevorzugten Ausführungsform dann in der aus der Gesamtheit der Register beim Auslesen erzeugten Signalwert-Folge jeweils die Position von mindestens zwei der mehreren Pegelwechsel summiert werden. Aus dieser Summe wird ein dann numerischer Wert erzeugt, der den Zeitpunkt des Eintreffens des Signals an der Messvorrichtung anzeigt.

Mit anderen Worten wird für die Umwandlung Signalwert- bzw. Bit-Folge in einen numerischen Wert die Summe der Positionen der Pegelwechsel herangezogen. Dies kann die Differentielle Nicht-Linearität (DNL) bei der Propagation der Pegelwechsel signifikant verringern, weil lokal unterschiedliche inhärente Verzögerungszeiten, die die Propagation der Pegelwechsel durch die Verzögerungsschaltung lokal unterschiedlich beeinflussen, quasi herausgemittelt werden.

Der Grund für diese Verbesserung liegt im Voranschreiten mehrerer Pegelwechsel in der Verzögerungsschaltung. Angenommen, die Flanke eines der Pegelwechsel befindet sich in einem Bereich von Verzögerungselementen mit hoher inhärenter Verzögerungszeit. Während dieser Zeit ändert sich ihre Position nicht. Sie trägt nicht zur Erhöhung der Summe der Positionen der Positionen der mehreren Pegelwechsel bei. Würde diese Position alleine betrachtet, würde die verstrichene Zeit überhaupt nicht berücksichtigt. Mit recht hoher Wahrscheinlichkeit befindet sich ein anderer der Pegelwechsel in einem Bereich von Verzögerungselementen mit zumindest durchschnittlicher inhärenter Verzögerungszeit. Bereits dies führt zu einer Mittelung der Propagation.

Mit einer gewissen Wahrscheinlichkeit durchschreitet die Flanke eines anderen Pegelwechsels jedoch eine Sequenz von Verzögerungselementen mit kleiner inhärenter Verzögerungszeit und ändert ihre Position somit häufig. Diese Flanke erhöht die Summe der Positionen in schnellen Schritten und kompensiert ggf. die langsamere Propagation der anderen Flanke sogar, zumindest teilweise.

In jedem Fall wird die Differentielle Nicht-Linearität (DNL) verringert. Dieses grundsätzlich bekannte Vorgehen wird als Wave Union Prinzip bezeichnet.

In praktischen Realisierungen des erfindungsgemäßen Verfahrens tritt häufig ein weiterer Effekt auf, der zu Ungenauigkeiten bei der Bestimmung des Zeitpunkts des Eintreffens des Signals an der Messvorrichtung zur Time-to-Digital-Konversion führt, wie nachstehend erläutert wird.

Ein typisches Problem ist, dass das Taktsignal, bspw. aufgrund unterschiedlicher Kabellängen in der Verschaltung oder sonstiger auch zufälliger Effekte, nicht genau gleichzeitig an den Takteingängen aller Register der Gesamtheit der Register (Ausleseregister) ankommt. Dadurch können einzelne Register einen falschen Signalwert übernehmen bzw. speichern. Wenn z.B. ein Register zu früh getaktet wird, gerade bevor der Pegelwechsel von dem Signalwert "0" auf den Signalwert "1" den Eingang des Registers erreicht, übernimmt das Register noch den an seinem Eingang anliegenden Signalwert "0". Der Pegelwechsel schreitet - unabhängig davon - in der Verzögerungsschaltung voran. Werden die übrigen Register zur "richtigen" Zeit bzw. zumindest später getaktet, übernehmen einige nachfolgende Register richtigerweise bereits den Pegelwechsel, d.h. speichern in dem Beispiel den Signalwert "1", den auch die vorangegangenen Register bereits übernommen haben. In diesem Beispiel ergibt sich in der Signalwert-Folge des Ausleseregisters somit ein "falscher" Signalwert "0" in der Sequenz von "richtigen" Signalwerten "1". Diese Effekte können also bewirken, dass es keinen definierten Pegelwechsel in der Signalwert- bzw. Bit-Folge des Ausgangsregisters gibt, oder diese Pegelwechsel mit anderen Worten in der Signalwert-Folge nicht genau bestimmt werden können.

Dies wird nachfolgend anhand eines schematischen Beispiels einer Signalwert-Folge mit Binärwerten (Bit-Folge) erläutert. Wie erläutert sollen die in das Ausleseregister eingeschriebenen Signalwerte theoretisch einen scharfen Übergang von einem auf den anderen Signalwert (d.h. einen definierten Pegelwechsel) zeigen, wie er nachstehend (von rechts nach links gelesen) für den Übergang von einem Signalwert "0" auf einen Signalwert "1" in einem Abschnitt des Ausleseregisters mit n=15 Werten dargestellt ist:
111111111000000

Der Pegelwechsel befindet sich scharf an dem Übergang von der sechsten zur siebten Position (Stelle) des Registerabschnitts (von rechts gelesen). Das heißt, dass ein vorausgehender Signalwert "1" an dieser Position scharf in einen Signalwert "0" übergeht (fallende Flanke).

Ein in einer realen Messschaltung erzeugter realer n-Bitwert kann bspw. aber wie folgt aussehen, wobei der vorbeschriebene Effekt mehrfach auftritt:
111110101000000

Hier lässt sich die Position des Pegelwechsels nicht eindeutig ermitteln. Dies bedeutet aber auch, dass die Propagationszeit des zu bestimmenden Pegelwechsels durch die Verzögerungsschaltung, und somit im Ergebnis der Zeitpunkt des Eintreffens des Signals an der Messvorrichtung, nicht genau bestimmt werden kann.

Es ist Stand der Technik, in diesem Falle nicht die Position des Pegelwechsels in der Signalwert- bzw. Bit-Folge für die Umwandlung in einen numerischen Wert heranzuziehen, sondern einen numerischen Wert durch Zählen der "1"-Bits (Signalwert "1") zu ermitteln. Die Anzahl der Signalwerte "1" in einer Signalwert-Folge wird als Population Count, Sideways-Sum oder Hamming Weight bezeichnet. Hier wird kurz von Population gesprochen. Es hat sich gezeigt, dass ein zur Auswertung der Signalwert-Folge auf dem Population Count basierender Encoder die negativen Effekte durch Metastabilitäten und Taktversatz minimieren kann.

Dies setzt allerdings voraus, dass nur ein Pegelwechsel in der Verzögerungsschaltung durchläuft, weil nur dann die Anzahl der Signalwerte / Bitwerte "1" ein Maß für die Position des Pegelwechsels in der Verzögerungsschaltung ist. Ein weiterer Pegelwechsel beeinflusst die Anzahl der Signalwerte "1" in der Signalwert-Folge systematisch. Das Zählen der Signalwerte "1" kann dann nicht zur Korrektur herangezogen werden. Weil erfindungsgemäß immer eine Sequenz von Pegelwechseln in die Verzögerungsschaltung eingespeist wird, stellt sich dieses Problem immer, und nicht nur dann, wenn der den Zeitpunkt des Eintreffens des Signals an der Messvorrichtung anzeigende numerischer Wert unter Verwendung der Summe der Positionen von mindestens zwei oder mehr Pegelwechseln ermittelt wird, d.h. nach dem Wave-Union-Prinzip.

Um auch die Auswertung nach dem Population Count bei der vorliegenden Erfindung (mit oder ohne Anwendung des Wave-Union-Prinzips) anwenden zu können, wird erfindungsgemäß nach einer besonders bevorzugten Ausführungsform vorgeschlagen, dass die Reihe der (jeweils einem der Verzögerungselementen der Verzögerungsschaltung zugeordneten) Register in mehrere Registersegmente unterteilt wird und für jedes Registersegment separat eine Bestimmung der Population dieses Registersegments mit einem vorgegebenen diskreten Signalwert erfolgt, beispielsweise also mit dem Signalwert "1" eines binären Signals. Durch die Aufteilung der gesamten Verzögerungsschaltung respektive der Gesamtheit der Register (Ausleseregister) in separate Segmente ist es möglich, die Bestimmung der Population dieses Segments als Korrektur zu verwenden, um unscharfe Pegelwechsel in der Signalwert-Folge zu korrigieren und effektiv eine genauere Bestimmung der Flanken im Hinblick auf deren zeitliche Lage zum Systemtakt zu ermöglichen.

Diese erfindungsgemäß vorgeschlagene Aufteilung der Verzögerungsschaltung in einzelne Segmente stellt auch eine eigenständige Erfindung dar, die unabhängig von der beschriebenen Einspeisung des Signals als Sequenz von Pegelwechseln in die Verzögerungsschaltung und das Ausbilden eines Austritts-Zählers für das Austreten dieser Pegelwechsel aus der Verzögerungsschaltung eingesetzt werden kann, wenn mehrere Pegelwechsel gleichzeitig in die Verzögerungsschaltung eingespeist sind und das Wave-Union-Prinzip angewendet werden soll.

Im Rahmen einer solchen Segmentierung kann besonders bevorzugt vorgesehen sein, dass durch die in die Verzögerungsschaltung eingespeiste Sequenz von Pegelwechseln und/oder mehreren gleichzeitig in die Verzögerungsschaltung eingespeisten Pegelwechseln höchstens ein Pegelwechsel in einem Registersegment (respektive einem entsprechenden Segment der Verzögerungsschaltung) auftritt. Dies kann bspw. durch ein Einspeiseschema sichergestellt werden, das einem Pulsgenerator zur Erzeugung der Pegelwechsel vorgegeben wird. Hierdurch wird sichergestellt, dass die Bestimmung der Population in jedem Propagationszustand der Pegelwechsel durch die Verzögerungsschaltung möglich ist. Besonders vorteilhaft ist es, wenn benachbart zu einem Segment mit einem Pegelwechsel respektive Signal mindestens ein Segment ohne Pegelwechsel, d.h. mit nur einem der diskreten Signalwerte, ausgebildet wird.

Gemäß einer besonders bevorzugten Ausgestaltung kann vorgesehen sein, dass die Reihe der Verzögerungselemente respektive Register in vier (insbesondere gleich große) Segmente eingeteilt wird und der Abstand zweier aufeinander folgender Pegelwechsel mindestens 3/8 der Gesamtlänge der Verzögerungsschaltung (oder gleichbedeutend damit einer diesem Verhältnis in etwa entsprechenden der Anzahl der Verzögerungselemente respektive Register) beträgt. Dies ist gleichbedeutend damit, dass der zeitliche Abstand der aufeinander folgenden Pegelwechsel 3/8 der gesamten Durchlaufzeit eines Pegelwechsels durch die Verzögerungsschaltung entspricht. Hierdurch kann zuverlässig sichergestellt werden, dass in einem Segment höchstens ein Pegelwechsel auftritt. Es versteht sich jedoch, dass im Rahmen des fachmännischen Handelns auch andere Ausgestaltungen realisiert werden können, mit denen sichergestellt werden kann, dass maximal ein Pegelwechsel pro Segment erfolgt.

Neben dem vorbeschriebenen Verfahren zur Time-to-Digital-Konversion betrifft die Erfindung auch einen Time-to-Digital-Konverter nach Anspruch 8, der bzw. dessen Steuereinrichtung zur Durchführung des vorbeschriebenen Verfahrens oder Teilen davon eingerichtet ist. Die Steuereinrichtung kann eine Einheit oder auf verschiedene Module oder Elemente des Time-to-Digital-Konverters aufgeteilt sein, die jeweils zur Durchführung eines Teils des Verfahrens so einrichtet sind, dass im Zusammenwirken das Verfahren durchgeführt wird. Im Folgenden wird der Teil des Verfahrens unabhängig davon im Zusammenhang mit dem jeweiligen Element oder Modul beschrieben, das zur Durchführung des Verfahren eingerichtet ist.

Ein hierfür vorgesehener Time-to-Digital-Konverter (im Sinne einer Messvorrichtung zur Bestimmung des Zeitpunkts des Eintreffens eines Signals an einer Messvorrichtung) weist insbesondere eine Verzögerungsschaltung, ein Ausleseregister, einen Pulsgenerator und einen Austritts-Zähler auf, die nachstehend ausführlicher beschrieben werden.

Die Verzögerungsschaltung umfasst eine Vielzahl von in Reihe geschalteten Verzögerungselementen mit mindestens einem Eingang und mindestens einem Ausgang, wobei der Ausgang eines der Verzögerungselemente jeweils mit dem Eingang des nachfolgenden Verzögerungselements verbunden ist. Die Verzögerungsschaltung ist dazu eingerichtet, ein an dem Eingang eines der Verzögerungselemente anliegendes Signal nach einer inhärenten Verzögerungszeit über seinen Ausgang an den Eingang des nachfolgenden Verzögerungselements zu übertragen, wobei ein (bspw. durch ein auslösendes Ereignis ausgelöstes und an dem Eingang eines der Verzögerungselemente eingespeistes) Signal einen Pegelwechsel zwischen einem ersten diskreten Signalwert und einem zweiten diskreten Signalwert hervorruft und wobei dieser Pegelwechsel über den Ausgang des Verzögerungselements jeweils an den Eingang des nachfolgenden Verzögerungselements übertragen wird. Das eingespeiste Signal selbst kann also als Pegelwechsel bezeichnet werden.

Das aus einer Vielzahl von Registern bestehende Ausleseregister ist derart aufgebaut, dass jedes Register einen Eingang und einen Ausgang und vorzugsweise einen Takteingang aufweist, wobei der Eingang jedes Register jeweils mit dem Ausgang genau eines der Verzögerungselemente verbunden ist in dem Sinne, dass jedem Verzögerungselement eineindeutig ein Register zugeordnet ist. Der Ausgang jedes der Register ist mit einem Encoder (insbesondere zur Digitalisierung der ausgegebenen diskreten Signalwerte) verbindbar oder verbunden. Jedes Register ist dazu eingerichtet, in einem Systemtakt den an dem Eingang des Registers anliegenden diskreten Signalwert zu speichern und über einen Ausgang des Registers auszugeben.

Der Systemtakt könnte grundsätzlich in jedem Register erzeugt werden. Es entspricht aber einer bevorzugten Ausführungsform, dass jedes Register einen Takteingang aufweist, der mit einem Taktgeber zur Erzeugung des Systemtakts respektive der Taktsignale verbunden ist. Dies kann ein lokaler Taktgeber, vorzugsweise aber ein (systemweit) globaler Taktgeber sein, um in einem System mit mehreren Time-to-Digital-Konvertern und/oder anderen Bestandteilen eine für alle Bestanteile gültige gleiche Systemzeit festzulegen. Dazu kann der Taktgeber einen mit jedem Taktsignal bzw. mit jeder bestimmten Flanke des Taktsignals (also dem Systemtakt) um den Wert eins inkrementierenden Zähler aufweisen, dessen Wert systemweit abrufbar ist, so dass ein bei einem bestimmten Systemtakt auftretendes Ereignis durch diesen Zähler im System zeitlich eindeutig festlegbar ist.

Erfindungsgemäß weist der Time-to-Digital-Konverter einen Pulsgenerator mit einem Eingang zum Aufschalten eines extern (bspw. durch ein auslösendes Ereignis) erzeugten Signals auf, wobei der Pulsgenerator dazu eingerichtet ist, das oder jedes an seinem Eingang aufgeschaltete Signal als eine Sequenz von Pegelwechseln in die Verzögerungsschaltung einzuspeisen, insbesondere durch Anlegen der Pegelwechsel an den Eingang mindestens eines der Verzögerungselemente. Die Sequenz kann dem Pulsgenerator bspw. durch ein geeignetes Einspeiseschema vorgegeben sein, wobei erfindungsgemäß vorgesehen ist, dass während der eingespeisten Sequenz von Pegelwechseln immer mindestens ein Pegelwechsel in die Verzögerungsschaltung eingespeist ist. Das bedeutet, das spätestens beim Austritt des einzigen Pegelwechsels aus der Verzögerungsschaltung entsprechend der Sequenz ein neuer Pegelwechsel in die Verzögerungsschaltung eingespeist wird.

Um diese erfindungsgemäße Anforderung an das Verfahren zur Time-To-Digital-Konversion zu erfüllen, könnte in einer besonders einfachen Ausführungsform der Ausgangszähler als Trigger auf das Einspeisen eines neuen Pegelwechsels eingespeist werden. Andere bevorzugte Ausführungsformen werden später noch beschrieben.

Schließlich ist erfindungsgemäß ein Austritts-Zähler am Ende der in Reihe geschalteten Verzögerungselemente vorgesehen, der mit dem Ausgang des letzten der in Reihe geschalteten Verzögerungselemente verbunden ist, wobei der Austritts-Zähler dazu eingerichtet ist, das Austreten jedes Pegelwechsels aus der Verzögerungsschaltung zu zählen.

Damit erfasst der Time-to-Digital-Konverter sämtliche der benötigten Datenwerte, um daraus in der bereits beschrieben Weise den Zeitpunkt des Eintreffens eines externen Signals an einer Messvorrichtung zu bestimmen und dessen Ausgabe als digitaler Wert zu ermöglichen. Dies kann bspw. mit durch die Steuereinrichtung erfolgen. Grundsätzlich kann die Steuereinrichtung erfindungsgemäß aber auch nur dazu eingerichtet zu sein, die zur Erfassung der benötigten Daten notwendigen Funktionen und Verfahrensschritte zu steuern. Die Auswertung und Aufbereitung der zur Verfügung gestellten Daten kann dann in einer anderen Einrichtung erfolgen, die nicht unbedingt Bestandteil des Time-to-Digital-Konverters sein muss. Bspw. kann diese Einrichtung über eine Schnittstelle mit dem Time-to-Digital-Konverter verbindbar sein, um auf die durch den Time-to-Digital-Konverter zur Verfügung gestellten Daten zuzugreifen.

Auch alle weiteren, bereits im Zusammenhang mit der Durchführung des Verfahrens beschriebenen Merkmale und Funktionen können erfindungsgemäß zusammen oder getrennt in beliebiger Kombination Gegenstand des erfindungsgemäßen Time-to-Digital-Konverters sein.

Gemäß einer bevorzugten Ausführungsform des erfindungsgemäß vorgeschlagenen Time-to-Digital-Konverters ist der Austritts-Zähler als Schieberegister ausgebildet, das eine Verkettung von mehreren Registern mit einem Eingang, einem Ausgang und einem Takteingang ist, wobei der Ausgang eines Registers mit dem Eingang des nachfolgenden Registers verbunden ist und die Takteingänge aller Register mit dem Ausgang des letzten Verzögerungselements verbunden sind. Erfindungsgemäß bevorzugt ist der Eingang des ersten Registers aus der Verkettung der mehreren Register mit einem konstanten Signalwert, vorzugsweise dem Signalwert "1" beaufschlagt. Der Initial-Zustand in jedem der Register des Schieberegisters ist dann vorzugsweise "0", d.h. der Ausgang jedes dieser Register des Schieberegisters hat den Signalwert (Pegel) "0".

Da der Takteingang aller Register des Schieberegisters mit dem Ausgang des letzten Verzögerungselements der Verzögerungsschaltung verbunden ist, aus dem jeder Pegelwechsel aus der Sequenz der Pegelwechsel aus der Verzögerungsschaltung ausläuft, wird so also jeder Taktwechsel gezählt. Bei dem ersten Taktwechsel wird also der konstante Signalwert (d.h. im Beispiel der Signalwert "1") auf den Ausgang des ersten Registers gelegt, der mit dem Eingang des zweiten Registers verbunden ist. Bei dem nächsten Pegelwechsel am Takteingang der Register wird der dieser Signalwert (d.h. im Beispiel der Signalwert "1") ein Register weitergeschoben, usw. Die Anzahl der Register mit diesem an dem Ausgang anliegenden Signalwert (d.h. im Beispiel dem Signalwert "1") gibt also die Anzahl der Pegelwechsel am Ausgang des letzten Verzögerungselements an.

In einer bevorzugten Realisierung des erfindungsgemäßen Time-to-Digital-Konverters sind zwei oder mehr Austritts-Zähler vorgesehen, wobei vorzugsweise jeweils ein Schieberegister für jeden festzugstellenden Pegelwechsel vorgesehen ist. In einer vorteilhaften Ausgestaltung, in der der Time-to-Digital-Konverter eine digital-elektronische Schaltung ist, sind entsprechend alle Signale binäre elektrische Signale mit zwei maßgeblichen Zuständen (d.h. dem Signalwert "0" und dem Signalwert "1", bspw. in Form entsprechender Pegel).

Insbesondere für eine solche Ausgestaltung ist es vorteilhaft, wenn zwei als Schieberegister ausgebildete Austritts-Zähler vorgesehen sind, wobei der erste der zwei Austritts-Zähler dazu eingerichtet ist, einen steigenden Pegelwechsel (steigende Flanke) am Ausgang des letzten Verzögerungselements zu zählen und wobei der zweite der zwei Austritts-Zähler dazu eingerichtet ist, einen fallenden Pegelwechsel (fallende Flanke) am Ausgang des letzten Verzögerungselements zu zählen, wobei die Takteingänge der Register sowohl des ersten Austritts-Zählers als auch des zweiten Austritts-Zählers mit dem Ausgang des letzten Verzögerungselements verbunden sind. Einfacher Weise kann der Takteingang der Register des einen Schieberegisters erfindungsgemäß invertiert sein, um auf eine fallende Flanke anzusprechen, während der Takteingang der Register des anderen Schieberegisters erfindungsgemäß nicht invertiert ist, um auf eine steigende Flanke anzusprechen. Dadurch wird die Zählrate der jeweiligen Austritts-Zähler vorteilhafter Weise halbiert, bzw. die maximale Gesamtzählrate beider Austritts-Zähler gemeinsam erhöht bzw. maximiert.

Um die Anzahl der aus der Verzögerungsschaltung ausgetretenen Pegelwechsel mit zu erfassen, ist in einer bevorzugten Ausführungsform vorgesehen, dass an jedem Ausgang eines Registers des Schieberegisters (vorzugsweise aller Austritts-Zähler) der Eingang eines weiteren Registers angeschlossen ist, wobei der Takteingang des weiteren Registers an den Systemtakt (d.h. an das Taktsignal) angeschlossen ist. Diese weiteren Register bilden ein Ausleseregister des Austritts-Zählers (bzw. der Austritts-Zähler) und können technisch mit in das Modul des Ausleseregisters der Verzögerungselemente integriert sein. Entsprechend wird im Systemtakt, d.h. mit dessen nächstfolgender Taktflanke, das Ausleseregister des Austritts-Zählers zusammen mit dem Ausleseregister der Verzögerungselemente ausgelesen. Mit diesen Informationen lässt sich der Zeitpunkt des Eintreffens des Signals an der Messvorrichtung genau bestimmten, weil sowohl die Anzahl der aus der Verzögerungsschaltung ausgetretenen Pegelwechsel als auch die aktuelle Position des Pegelwechsels in der Verzögerungsschaltung bekannt ist.

Eine besonders bevorzugte Ausführungsform sieht vor, dass die Verzögerungsschaltung als Addierer ausgebildet ist, wobei jedes der Verzögerungselemente der Verzögerungsschaltung ein Ein-Bit-Volladdierer ist, der zwei Summanden-Eingänge und einen Eingang für ein Carry-In-Signal (nachfolgend auch als Carry-In-Eingang bezeichnet) sowie einen Ausgang für ein Carry-Out-Signal (nachfolgend auch als Carry-Out-Ausgang bezeichnet) und einen Ausgang für ein Summen-Bit (nachfolgend auch als Summen-Bit-Ausgang bezeichnet) aufweist.

Der Volladdierer ist dazu ausgebildet, eine Addition aller drei Eingänge (d.h. der zwei Summanden-Eingänge und des Carry-In-Eingangs) durchzuführen und das Summenergebnis als zweistellige Binärzahl auszugeben, wobei das niedrigste Bit der zweistelligen Binärzahl (LSB - least significant bit) auf dem Summen-Bit-Ausgang und das höchste Bit der zweistelligen Binärzahl (MSB - most significant bit) auf dem Carry-Out-Ausgang ausgeben wird.

Einer der Summanden-Eingänge mindestens eines der Verzögerungselemente, vorzugsweise des ersten Verzögerungselements in der Reihe der Verzögerungselemente) ist mit einem ersten Ausgang des Pulsgenerators verbunden, wobei der Pulsgenerator dazu eingerichtet ist, die Pegelwechsel aus der Sequenz der Pegelwechsel über diesen ersten Ausgang auszugeben.

Der Carry-In-Eingang der Verzögerungselemente ist jeweils mit dem Carry-Out-Ausgang für das Signal des jeweils nächstvorderen Verzögerungselements aus der Reihe der Verzögerungselemente verbunden. Der Carry-In-Eingang des ersten Verzögerungselements aus der Reihe der Verzögerungselemente ist vorzugsweise mit einem Inaktiv-Pegel, insbesondere mit dem Signalwert "0", beaufschlagt.

Schließlich ist der Summen-Bit-Ausgang jedes Verzögerungselements mit dem Eingang jeweils eines (genau eines im Sinne eines definierten) Registers des Ausleseregisters verbunden.

So lässt sich die Verzögerungsschaltung einfach und kostengünstig mit programmierbaren Logikbauteilen, auch bekannt als FPGAs (Field Programmable Gate Array), realisieren. In der beschriebenen Implementation wird die als Addierer ausgebildete Verzögerungsschaltung auch als "Ripple Carry Adder" bezeichnet.

In einer bevorzugten Ausgestaltung werden die Summanden-Eingänge aller Verzögerungselemente - soweit sie nicht mit Ausgängen des Pulsgenerators verbunden sind - mit geeigneten, vorzugsweise konstanten, diskreten Signalwerten vorbelegt. Im Falle binärer Signale vorzugsweise mit den Signalwerten "0" und "1" an den beiden Summanden-Eingängen. Die genaue Funktion wird anhand von Ausführungsbeispielen noch beschrieben.

Gemäß einer bevorzugten Variante der Erfindung kann der Pulsgenerator zusätzlich mindestens einen Feedback-Eingang aufweisen, der mit dem Ausgang für das Summen-Bit eines auswählten Verzögerungselements verbunden ist. Somit wird in dem Feedback-Eingang des Pulsgenerators immer dann ein Pegelwechsel erzeugt, wenn auch an dem Ausgang dieses ausgewählten Verzögerungselements ein Pegelwechsel auftritt. Dieser Pegelwechsel am Feedback-eingang des Pulsgenerators kann verwendet werden, um in der Sequenz der in die Verzögerungsschaltung eingespeisten Pegelwechsel einen Pegelwechsel zu erzeugen, der bspw. über den ersten Ausgang des Pulsgenerators ausgegeben werden kann. Der Vorteil eines auf diese Weise erzeugten Pegelwechsels ist, dass die Pegelwechsel immer auf identische Weise aus den vorangegangenen Pegelwechseln erzeugt werden.

Ferner kann erfindungsgemäß vorgesehen sein, dass einer der Summanden-Eingänge eines weiteren der Verzögerungselemente mit einem zweiten Ausgang des Pulsgenerators verbunden ist, wobei der Pulsgenerator dazu eingerichtet ist, bei einem auf seinem Eingang aufgeschalteten Signal mindestens einen Pegelwechsel in die Verzögerungsschaltung durch Anlegen mindestens eines Pegelwechsels an den Eingang des weiteren Verzögerungselements einzuspeisen. Hierdurch wird erreicht, dass gleichzeitig zwei Pegelwechsel in die Verzögerungsschaltung eingespeist werden und diese durchlaufen. Hierdurch kann das bereits beschriebene Wave-Union-Prinzip in einer einfachen Form realisiert werden. Grundsätzlich ist es erfindungsgemäß auch möglich, mehr als zwei Pegelwechsel gleichzeitig in die Verzögerungsschaltung einzuspeisen, indem Summanden-Eingänge weiterer Verzögerungselemente mit einem Pegelwechsel beaufschlagt werden. Dazu kann der Plusgenerator bspw. weitere Ausgänge aufweisen.

Eine weitere Ausführungsform der Erfindung sieht vor, dass das Ausleseregister der Verzögerungselemente in mehrere, vorzugsweise vier gleich große Registersegmente eingeteilt ist. Erfindungsgemäß kann Steuereinrichtung dazu eingerichtet sein, für jedes der Registersegmente einen Population Count, d.h. die Anzahl des Vorkommens eines bestimmten Signalwerts, insbesondere des Signalwerts "1" oder "0" bei binären Signalen, in den Registersegmenten zu zählen, der ein Maß für die Position eines Pegelwechsels in einem Registersegment ist. Dieses Vorgehen wurde bereits beschrieben. Ergänzend kann für jedes Registersegment eine Kennung vorgesehen sein, wenn in dem Registerabschnitt nur einer der möglichen Signalwerte gespeichert ist, bspw. nur der Signalwert "0" und/der nur der Signalwert "1". Eine solche Kennung beschleunigt die Auswertung der einzelnen Registerabschnitte erheblich.

Dieses erfindungsgemäß vorgeschlagene Verfahren und die Durchführung dies Verfahrens in dem erfindungsgemäß vorgeschlagenen Time-to-Digital-Konverter haben den Vorteil, dass der schaltungstechnische Aufwand für die Verzögerungsschaltung (insbesondere einer Tapped-Delay-Line und damit auch für den Encoder, der die Register der einzelnen Verzögerungselemente ausliest und in eine verarbeitbare digitale Zahl umwandelt) erheblich reduziert wird, weil die Länge der Verzögerungsschaltung gegenüber dem bekannten Stand der Technik erheblich verkürzt werden kann. Dadurch ist es auch möglich, mehr Messkanäle auf einem gegebenen programmierbaren Bauteil (FPGA) zu implementieren, was wiederum den Platzbedarf und den finanziellen Aufwand reduziert. Ebenso kann die abgegebene Wärmeleistung reduziert werden.

Weitere Merkmale, Vorteile und Abwendungsmöglichkeiten der vorliegenden Erfindung ergeben sich auch aus der nachfolgenden Beschreibung konkreter Ausführungsbeispiele und der Zeichnung. Dabei bilden alle beschriebenen und/oder bildlich dargestellten Merkmale den Gegenstand der vorliegenden Erfindung, auch unabhängig von ihrer Zusammenfassung in den Ansprüchen und deren Rückbezügen.

Es zeigen:
- Fig. 1: schematisch eine Ausführungsform einer bei einem Time-to-Digital-Konverter nach der vorliegenden Erfindung eingesetzten Verzögerungsschaltung;
- Fig. 2: beispielhaft einen bestimmten Zustand der Verzögerungsschaltung nach Fig. 1;
- Fig. 3: schematisch das Verfahren zur Bestimmung des Zeitpunkts des Eintreffens eines externen Signals anhand der in Fig. 1 dargestellten Verzögerungsschaltung;
- Fig. 4: schematisch eine erste einfache Ausführungsform eines Time-to-Digital-Konverters gemäß der vorliegenden Erfindung;
- Fig. 5: schematisch eine vorteilhafte Ausführungsform eines Austritts-Zählers eines Time-to-Digital-Konverters gemäß der vorliegenden Erfindung; und
- Fig. 6: schematisch eine zweite Ausführungsform eines Time-to-Digital-Konverters gemäß der vorliegenden Erfindung;

Mit Bezug auf die Zeichnung werden nachstehend Ausführungsformen eines erfindungsmäßen Time-to-Digital-Konverters 10, 20 (Zeit-zu-Digital-Konverter) in wesentliche Merkmale der Erfindung realisierenden Ausführungsformen beschrieben. Mit diesem Time-to-Digital-Konverter kann das erfindungsgemäße Verfahren zur Time-to-Digital-Konversion (Verfahren zur Zeit-zu-Digital-Konversion) ausgeführt werden, das bereits ausführlich beschrieben ist. Diese Beschreibung wird hier nicht wiederholt. Es versteht sich aber, dass der Fachmann das beschriebene Verfahren oder Teile hiervon in einem Time-to-Digital-Konverter 10, 20 implementieren kann.

Der in Figur 4 gezeigte Time-to-Digital-Konverter 10 umfasst eine mit Bezug auf die Figuren 1 bis 3 bereits ausführlich beschriebene Verzögerungsschaltung 100 mit Verzögerungselementen 101 und Registern 105. Details dieser Elemente und ihre Merkmale und Funktionen wurden in Zusammenhang mit den Figuren 1 bis 3 bereits ausführlich beschrieben. Alle diese Ausführungen gelten auch für den Time-to-Digital-Konverters 10 (sowie anlog auch für die zweite beschriebene Ausführungsform eine Time-to-Digital-Konverters 20) und werden an dieser Stelle nicht widerholt.

Ergänzend weist der Time-to-Digital-Konverter 10 einen Pulsgenerator 130 auf, an dessen Eingang 131 das Signal 108 eintrifft, wobei der Zeitpunkt des Eintreffens dieses Signals 108 in der grundsätzlich bereits beschriebenen Art und Weise bestimmt wird.

Der Pulsgenerator 130 ist dazu eingerichtet, das an seinem Eingang 131 anliegende bzw. aufgeschaltete Signal über seinen Ausgang 132 als eine Sequenz von Pegelwechseln 108 in die Verzögerungsschaltung 100 einzuspeisen. Hierzu werden die Pegelwechsel 108 aus der Sequenz der Pegelwechsel 108 an dem Eingang 102 des ersten Verzögerungselements 101 eingespeist. Diese Pegelwechsel 108 durchwandern die Verzögerungsschaltung in der bereits beschriebenen Weise und treten am Ausgang des letzten Verzögerungselement 101 der Verzögerungsschaltung 100 wie beschrieben wieder aus. Der Zustand der Verzögerungselemente 101 wird in der beschriebenen Weise mit dem Systemtakt 54 mittels der Register 105, die gemeinsam ein Ausleseregister der Verzögerungselemente 101 bilden, ausgelesen.

Am Ausgang 103 des letzten Verzögerungselements 101 ist ein Austritts-Zähler 150 ausgebildet, der dazu eingerichtet ist, das Austreten jedes Pegelwechsels 108 aus der Verzögerungsschaltung 10 zu zählen. Der Austritts-Zähler 150 ist als ein entsprechend Figur 5 näher beschriebenes Schieberegister 150 ausgebildet, an das weitere Register 151 und 152 anschlossen sind, die zusammen ein Ausleseregister des Austritts-Zählers 150 bilden. Der Austritts-Zähler kann so realisiert sein, dass dieser eigentlich zwei verschieden konfigurierte austriffts-Zähler 150 umfasst.

Aus dem bei dem Systemtakt 54 ausgelesen Zustand der Verzögerungsschaltung 100 und des Ausleseregisters 151, 152 des Austritts-Zählers 105 lässt sich der Zeitpunkt des Eintreffen des Signals an dem Time-to-Digital-Konverter 10 relativ zu dem Systemtakt, wie bereits beschrieben, genau bestimmen, weil die Sequenz und die Anzahl der durch die Verzögerungsschaltung 100 durchgelaufenen Pegelwechsel 108 bekannt sind und sich die Position der noch in der Verzögerungsschaltung 100 durchlaufenden Pegelwechsel 108 aus dem Zustand der Verzögerungsschaltung 100 ergibt, respektive aus den aus den Registern 105 ausgelesenen Signalwerten.

Eine besonders vorteilhafte Ausgestaltung des Austritts-Zähler 150 mit den wird nachfolgend mit Bezug auf Figur 5 beschrieben.

Der Austritts-Zähler 150 umfasst streng genommen zwei Austritts-Zähler 150, wobei der erste Austritts-Zähler 150 dazu eingerichtet ist, einen steigenden Flankenwechsel am Ausgang 103 des letzten Verzögerungselement 101 zu zählen, wobei der zweite der zwei Austritts-Zähler 150 dazu eingerichtet ist, einen fallenden Flankenwechsel am Ausgang 103 des letzten Verzögerungselement 101 zu zählen. Die Anzahl der fallenden Flankenwechsel kann in den Registern 151, und die Anzahl der steigenden Flankenwechsel kann in den Registern 152 abgelesen werden.

Aufbau und Funktion der als Schieberegister ausgebildeten Austritts-Zähler 150 wird nun näher erläutert.

Der Austritts-Zähler 150 für die fallende Flanke umfasst eine Verkettung von mehreren Registern 153 mit jeweils einem Eingang 155, einem Ausgang 156 und einem Takteingang 157, wobei der Ausgang 156 eines Registers 153 mit dem Eingang 155 des nachfolgenden Registers 153 verbunden ist und die Takteingänge 157 aller Register 153 mit dem Ausgang 103 des letzten Verzögerungselements 101 (in Figur 5 nicht dargestellt) verbunden sind.

Dies gilt für den Ausstritts-Zähler 150 für die steigende Flanke in derselben Weise, der eine Verkettung von Registern 154 aufweist. Die Register 153 und 154 sind grundsätzlich gleich aufgebaut. Weil die Takteingänge 157 standardmäßig auf eine steigende Flanke im ausgewerteten Signal ansprechen, sind die Takteingänge der Register 153 mit einer Invertierung 159 versehen, so dass das Register 153 bei einer fallenden Flanke getaktet wird. Je nach Flanke (steigend oder fallend) sprechen in dieser Art der Schaltung der Register 153, 154 also nur die jeweils betroffenen Register 153, 154 an; die anderen Register 154, 153 ignorieren die durch sie nicht zu zählende Flanke.

Bei den jeweils ersten Registern 153, 154 der beiden Austritts-Zähler liegt ein fester Signalwert "1" am Eingang der Register 153, 154 an. Mit einem Reset-Signal 160, bspw. zu Beginn jeder neuen Messung, an dem Reseteingang 158 wird der in den Registern 153, 154 auf den Anfangswert "0" gesetzt.

Mit jedem aus der Verzögerungsschaltung 100 austretenden Pegelwechsel 108, der einen Takt in den jeweiligen Registern 153 bzw. 154 auslöst, wird also der Signalwert "1" um ein Register 153 bzw. 154 (d.h. um eine Position im jeweiligen Schieberegister 150) weitergeschoben. In den (bspw. über einen Takteingang auch mit dem Systemtakt 54) getakteten weiteren Registern 151, 152 (als Ausleseregister der Schieberegister 150) ergeben sich auch hier zwei (kürzere) Thermometer-Codes, deren Anzahl von Signalwerten "1" die Zahl der bis dato ausgetretenen steigenden oder fallenden Pegelwechsel 108 angibt.

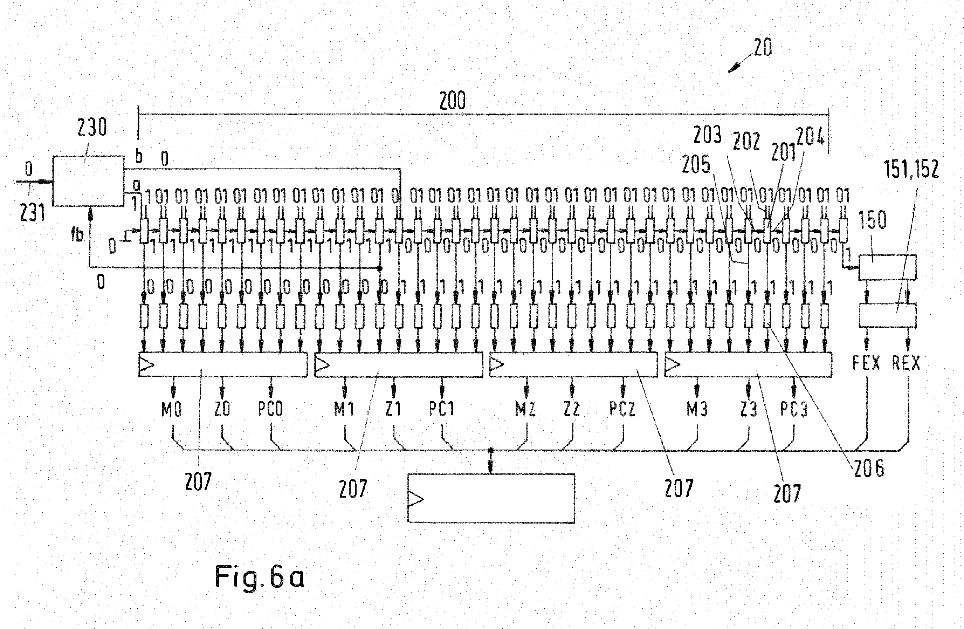

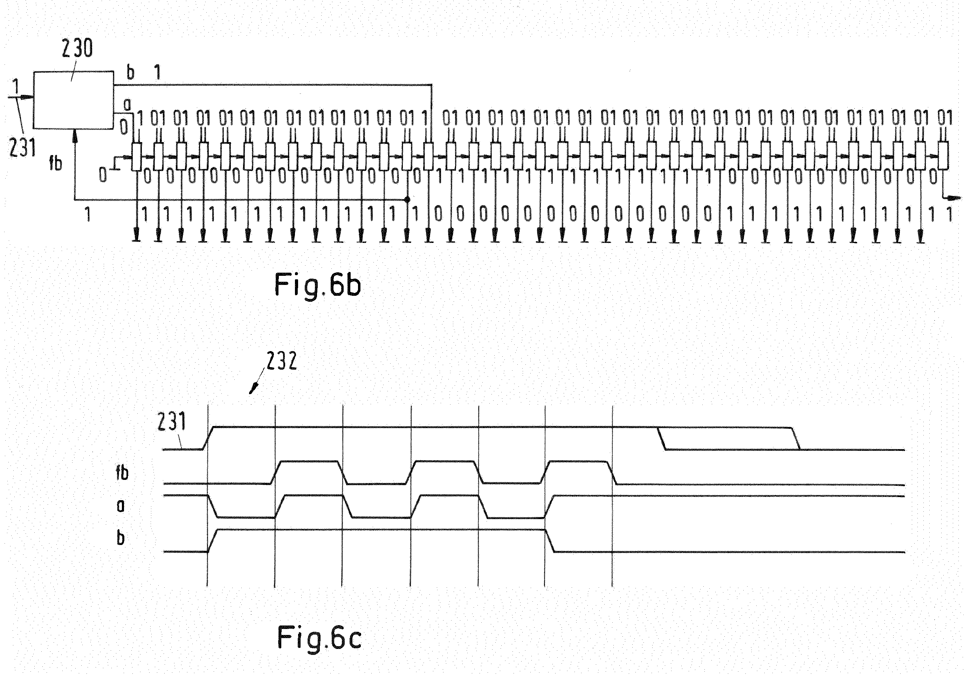

Dieser Austrittszähler 150 mit dem Ausleseregister 151, 152 des Austrittszählers 105 findet auch Anwendung bei einer aufwendigeren Ausführungsform eines erfindungsgemäßen Time-to-Digital-Konverters 20, der mit Bezug auf Figur 6 nachfolgend beschrieben wird.

Die Grundfunktionen der dort realisieren Verzögerungsschaltung 200 entsprechen denen der bereits ausführlich beschriebenen Verzögerungsschaltung 100. Diese werden nicht noch einmal beschrieben, weil der Fachmann in der Lage ist, die Funktionen entsprechend auch bei der Verzögerungsschaltung 200 zu verstehen und zu implementieren.

Die nachfolgende Beschreibung konzentriert sich daher auf die Beschreibung wichtiger Ergänzungen zu der bisherigen Verzögerungsschaltung 100 in der

Figur 6a.

Der in dieser Ausführungsform beschriebene Time-to-Digital-Konverter 20 weist eine als Addierer ausgebildete Verzögerungsschaltung 200 auf. Jedes der Verzögerungselemente 201 der Verzögerungsschaltung 200 weist einen Ein-Bit-Volladdierer auf, der seinerseits zwei Summanden-Eingänge 202 aufweist, die - soweit sie nicht mit einem Pulsgenerator 203 verbunden sind - fest mit einem Signalwert vorbelegt sind. In dem Beispiel sind dies die Signalwerte "0" und "1", die jeweils einen der beiden Summanden-Eingänge 202 zugewiesen sind. Die Signalwerte sind zur Erläuterung als 0 oder 1 in Figur 6 eingetragen.

Ferner ist ein Eingang 203 für ein Carry-In-Signal 203 vorgesehen. Jedes Verzögerungselement 201 weist auch einen Ausgang 204 für ein Carry-Out-Signal und einen Ausgang 205 für ein Summen-Bit auf.

Das als Ein-Bit-Volladdierer gestaltete Verzögerungselement 201 ist dazu ausgebildet, eine Addition aller drei Eingänge 202, 203 durchzuführen und das Summenergebnis als zweistellige Binärzahl auszugeben, wobei das niedrigste Bit der zweistelligen Binärzahl auf dem Ausgang 205 für das Summen-Bit und das höchste Bit der zweistelligen Binärzahl auf dem Ausgang 24 für das Carry-Out-Signal ausgeben werden.

Einer der Summanden-Eingänge 202 des ersten Verzögerungselements 201, nämlich der bei den anderen Verzögerungselementen 201 mit dem Signalwert "0" belegte Summanden-Eingang 202, ist mit einem ersten Ausgang a eines Pulsgenerators 230 verbunden. Der Eingang 203 für das Carry-In-Signal ist bei dem ersten Verzögerungselement fest mit dem Signalwert "0" vorbelegt.

Einer der Summanden-Eingänge 202 eines weiteren Verzögerungselements 201, nämlich der bei den anderen Verzögerungselementen 201 mit dem Signalwert "1" belegte Summanden-Eingang 202 ist mit einem zweiten Ausgang b des Pulsgenerators 230 verbunden. In dem dargestellten Beispiel ist dies das vierzehnte Verzögerungselement 201. In einer realen Ausführung kann dies natürlich auch ein anderes Verzögerungselement 201, bspw. das zwanzigste (oder ein geeignet ausgewähltes anderes) Verzögerungselement 201, sein.

Abgesehen von dem ersten Verzögerungselement 201 ist der Eingang 203 für das Carry-In-Signal der Verzögerungselemente 201 jeweils mit dem Ausgang 204 für das Carry-Out-Signal des jeweils nächstvorderen Verzögerungselements 201 aus der Reihe der Verzögerungselemente verbunden. Mit Ausnahme des letzten Verzögerungselements 201 ist Ausgang 205 für das Summen-Bit jedes Verzögerungselements 201 mit dem Eingang jeweils eines Registers 206 eines Ausleseregisters verbunden, mit dem der Status der Verzögerungsschaltung 200 in der grundsätzlich auf für die für die Verzögerungsschaltung 100 beschriebenen Weise abgefragt werden kann. Dies wird nicht mehr ausführlich erläutert.

Der Pulsgenerator 230 weist zusätzlich einen Feedback-Eingang fb auf, der mit dem Ausgang 205 für das Summen-Bit eines auswählten Verzögerungselements 201 verbunden ist, in dem dargestellten Beispiel dem dreizehnten Verzögerungselement 201.

An einem Eingang 231 des Pulsgenerators wird ein Signal aufgeschaltet, dessen Eintreffen an dem Time-to-Digital-Konverter bestimmt werden soll. In dem in Figur 6a dargestellten Fall liegt kein Signal an dem Eingang 231 an, wie durch den Signalwert "0" an dem Eingang 231 angezeigt. Figur 6a zeigt den Initialzustand der Verzögerungsschaltung, solange noch kein Signal anliegt.

Die Summanden-Eingänge 202 des ersten Verzögerungselements 201 tragen jeweils den Wert "1". An dem Carry-In-Eingang 203 liegt der Signalwert "0" an. In der Summe ergibt sich der Dezimalwert zwei, der als binär als Folge "10" dargestellt wird. Das niedrigste Bit "0" wird an dem Ausgang 205 für das Summen-Bit an das Register 206 ausgeben. Das höchste Bit "1" wird über den Ausgang 204 für das Carry-out-Signal an den Eingang 203 des nächsten Verzögerungselements 201 übertragen.

In dem nächsten Verzögerungselement ergibt sich damit auch der Dezimalwert zwei für die Summe (Summanden-Eingänge 202 mit den Signalwerten "1" und "0" und Carry-In-Eingang 203 mit dem Signalwert "1"). Diese Berechnungsmethode gilt allgemein für alle Verzögerungselemente 201. So stellt sich der in Figur 6a dargestellte Initialzustand ein, in dem noch kein Signal im Sinne eines Flankenwechsels 108 an dem Eingang 231 der Pulsgenerators 230 anliegt. Dort liegt insoweit konstant der Pegel "0", der invertiert an dem Ausgang a ausgebgeben wird (Signalwert "1").

An dem Ausgang b des Pulsgenerators 230 wird der anliegende Signalpegel nicht invertiert ausgegeben (Signalwert "0"). Auch an dem Feedback-Eingang fb liegt im Initialzustand der Wert "0" an. Beispielsweise kann der Feedback-Eingang fb in dem Pulsgenerator 230 so verwendet werden, dass während der Ausgabe der Pegelwechsel 108 in der Sequenz der Signalpegel das Ausgangs "a" ergänzend noch einmal invertiert wird, wenn der Feedback-Eingang fb den Signalwert "1" ausgibt.

Die Dauer der Sequenz kann bspw. fest vorgegeben werden, bspw. durch Zählen der Flankenwechsel an dem Feedback-Eingang fb oder auf andere Weise. Hierdurch lässt sich ein Einspeiseschema 232 für den Pulsgenerator 230 erzeugen, wie es in Figur 6c dargestellt ist. Grundsätzlich ließe sich die Erfindung auch mit einem anderen Einspeiseschema 232 realisieren.

Der Initial-Zustand der Verzögerungsschaltung 200, wie in Figur 6a gezeigt, kann wie folgt beschrieben werden: die ersten dreizehn Verzögerungselemente 201 haben einen Signalwert "0" am Summen-Bit-Ausgang 205, während das vierzehnte und alle folgenden Verzögerungselemente 201 einen Signalwert "1" am Summen-Bit-Ausgang 205 haben. Dies wird durch das Einspeisen des Signals über den Ausgang b des Pulsgenerators 230 bewirkt und führt dauerhaft dazu, dass immer zwei Pegelwechsel durch die Verzögerungsschaltung 200 durchwandern und das Wave-Union-Prinzip bei der Auswertung angewandt werden kann. Der in Figur 6a dargestellte Initial-Zustand entspricht Zustand vor dem ersten senkrechten Strich durch das Einspeiseschema 232.

Nach Eintreffen eines Pegelwechsels 108 von "0" auf "1" des messenden Signals (bei dem ersten senkrechten Strich des Einspeiseschemas 232 gemäß Figur 8c) setzt sich dieser 0-Puls der Länge von dreizehn Verzögerungselemente 201 in Richtung des Endes der Verzögerungsschaltung 200 in Bewegung, d.h. vom Anfang der Verzögerungsschaltung 200 her setzt sich ein Pegelwechsel 108 von "0" auf "1" mit der den Verzögerungselements 201 inhärenten Verzögerungszeit in Bewegung, während sich gleichzeitig vom vierzehnten Verzögerungselement an ein Pegelwechsel von "1" auf "0" in Bewegung setzt. Diese Beobachtung bezieht sich auf die Summen-Bit-Ausgänge 205 der einzelnen Verzögerungselemente 201.

In Figur 6b ist der Zustand der Verzögerungsschaltung an dem zweiten senkrechten Strich des Einspeiseschemas 232 dargestellt, bei dem der am ersten Verzögerungselement 201 eingespeiste Pegelwechsel von "0" auf "1" dreizehn Verzögerungselemente 201 weitergewandert ist. In diesem Zustand hat der Pegelwechsel im dreizehnten Verzögerungselement auch den Feedback-Eingang fb erreicht, der nun das Ausgangssignal a wieder invertiert, d.h. von "1" auf "0" umschaltet. Dies bewirkt auch einen Pegelwechsel von "1" auf "0" am Summen-Bit-Ausgang 205 des ersten Verzögerungselements 201, der im Weiteren durch die Verzögerungsschaltung durchwandert.

Außerdem ist Figur 6a zu entnehmen, dass das Ausleseregister als Gesamtheit der Register 206 in vier gleich große Registersegmente 207 (im Sinne von Registerabschnitten) eingeteilt ist, wobei jedes der Registersegmente 207 eine Kennung M aufweist, wenn alle Signalwerte in dem Registersegment 207 den Wert "1" annehmen, eine Kennung Z aufweist, wenn alle Signalwerte in dem Registersegment 207 den Wert "0" annehmen, und/oder eine Information PC aufweisen, die die Anzahl der in dem Registersegment 207 enthaltenen Signalwerte "1" widergibt.

Mit dem in Figur 6 realisierten Time-to-Digital-Konverter 20 kann das erfindungsgemäß vorgeschlagene Verfahren mit gemeinsamer Anwendung des Wave-Union-Prinzips und des Population-Count-Verfahrens durchgeführt werden.

### Bezugszeichenliste

- 10: Time-to-Digital-Konverter als Messvorrichtung
- 20: Time-to-Digital-Konverter als Messvorrichtung

- 50: Taktsignal
- 51: zeitlicher Abstand zwischen Pegelwechseln des Taktsignals
- 52: positive Taktflanke
- 53: negative Taktflanke
- 54: Systemtakt
- 55: Eintreffen eines Signals an der Messvorrichtung
- 56: Zeitspanne
- 57: Eintreffen eines Signals an der Messvorrichtung
- 58: Zeitspanne
- 100: Verzögerungsschaltung, auch als Tapped Delay Line bezeichnet
- 101: Verzögerungselement
- 102: Eingang des Verzögerungselements
- 103: Ausgang des Verzögerungselements
- 104: Eingang des Registers
- 105: Register
- 106: Ausgang des Registers
- 107: Signalwert-Folge
- 108: Signal / Pegelwechsel

- 130: Pulsgenerator
- 131: Eingang
- 132: Ausgang

- 150: Austritts-Zähler
- 151: weitere Register des Ausleseregisters für Pegelwechsel mit fallender Flanke
- 152: weitere Register des Ausleseregisters für Pegelwechsel mit steigender Flanke
- 153: Register der Austritts-Zähler
- 154: Register der Austritts-Zähler
- 155: Eingang
- 156: Ausgang
- 157: Takteingang
- 158: Reseteingang
- 159: Invertierung
- 160: Reset-Signal

- 200: Verzögerungsschaltung
- 201: Verzögerungselement
- 202: Summanden-Eingänge
- 203: Eingang für ein Carry-In-Signal
- 204: Ausgang für ein Carry-Out-Signal
- 205: Ausgang für ein Summen-Bit
- 206: Register
- 207: Registersegmente

- 230: Pulsgenerator
- 231: Eingang des Pulsgenerators
- 232: Einspeiseschema
- a: erster Ausgang des Pulsgenerators
- b: zweiter Ausgang des Pulsgenerators
- fb: Feedback-Eingang

## Patentansprüche

1. Verfahren zur Time-to-Digital-Konversion, mit dem der Zeitpunkt des Eintreffens eines Signals an einer Messvorrichtung (10, 20) bestimmt wird,
- wobei das an der Messvorrichtung (10, 20) eintreffende Signal (108) in eine Verzögerungsschaltung (100, 200) aus einer Vielzahl von in Reihe geschalteten Verzögerungselementen (101, 201) eingespeist wird, die einen Eingang (102; 202, 203) und Ausgang (103; 204, 205) aufweisen, wobei der Ausgang (103; 204) eines der Verzögerungselemente (101, 201) jeweils mit dem Eingang (102, 203) des nachfolgenden Verzögerungselements verbunden ist, so dass ein an dem Eingang (102; 202, 203) eines der Verzögerungselemente (101, 201) anliegendes Signal (108) nach einer inhärenten Verzögerungszeit über seinen Ausgang (103; 204) an den Eingang (102, 203) des nachfolgenden Verzögerungselements (101, 201) übertragen wird,
- wobei das eingespeiste Signal an dem Eingang (102; 202, 203) eines der Verzögerungselemente (101, 201) einen Pegelwechsel (108) zwischen einem ersten diskreten Signalwert und einem zweiten diskreten Signalwert hervorruft und wobei dieser Pegelwechsel (108) über den Ausgang (103; 204) des Verzögerungselements (101, 201) jeweils an den Eingang (102; 203) des nachfolgenden Verzögerungselements (101, 201) übertragen wird, und
- wobei der Ausgang (103; 205) jedes Verzögerungselements (101, 201) jeweils auch mit einem Eingang (104) eines Registers (105, 206) verbunden ist und der an dem Eingang (104) des Registers (105, 206) anliegende diskrete Signalwert in einem durch ein in einer bestimmten Taktperiode auftretendes Taktsignal vorgegebenen Systemtakt (54) gespeichert und über einen Ausgang (106) des Registers (105, 206) ausgegeben wird,
- wobei das eintreffende Signal (108) mittels eines Pulsgenerators (130, 230) als eine Sequenz von Pegelwechseln (108) in die Verzögerungsschaltung (100, 200) eingespeist wird,
**dadurch gekennzeichnet, dass**
das Austreten jedes Pegelwechsels (108) am Ende der in Reihe geschalteten Verzögerungselemente (101, 201) in einem Austritts-Zähler (150) gezählt wird.

2. Verfahren nach Anspruch 1, **dadurch gekennzeichnet, dass** jeweils ein separater Austritts-Zähler (150) für verschiedene Pegelwechsel (108) vorgesehen wird.

3. Verfahren nach Anspruch 2, **dadurch gekennzeichnet, dass** jeder der Austritts-Zähler (150) als ein Schieberegister ausgebildet wird.

4. Verfahren nach einem der vorhergehenden Ansprüche, **dadurch gekennzeichnet,** die Sequenz von Pegelwechseln (108) so in die Verzögerungsschaltung (100, 200) eingespeist wird, dass sich mehrere Pegelwechsel (108) gleichzeitig in der Verzögerungsschaltung (100, 200) befinden.

5. Verfahren nach Anspruch 4, **dadurch gekennzeichnet, dass** in einer aus der Gesamtheit der Register (105, 206) beim Auslesen erzeugten Signalwert-Folge jeweils die Position von mindestens zwei der mehreren Flankenwechsel (108) summiert wird und aus der Summe ein numerischer Wert erzeugt wird, der den Zeitpunkt des Eintreffens des Signals (108) an der Messvorrichtung (10, 20) anzeigt.

6. Verfahren nach einem der vorhergehenden Ansprüche, **dadurch gekennzeichnet, dass** die Reihe der Register (206) in mehrere Registersegmente (207) des Ausleseregisters unterteilt wird und für jedes Registersegment (207) separat eine Bestimmung der Population dieses Registersegments (207) mit einem vorgegebenen diskreten Signalwert erfolgt.

7. Verfahren nach Anspruch 6, **dadurch gekennzeichnet, dass** durch die in die Verzögerungsschaltung (100, 200) eingespeiste Sequenz von Pegelwechseln (108) und/oder mehreren gleichzeitig in die Verzögerungsschaltung (100, 200) eingespeisten Pegelwechseln (108) höchstens ein Pegelwechsel (108) in einem Registersegment (207) auftritt.

8. Time-to-Digital-Konverter mit einer zur Durchführung des Verfahrens nach einem der vorhergehenden Ansprüchen eingerichteten Steuereinrichtung zur Bestimmung des Zeitpunkts des Eintreffens eines Signals (108) an der als Time-to-Digital-Konverter ausgebildeten Messvorrichtung (10, 20), wobei der Time-to-Digital-Konverter (10, 20) aufweist:
- eine Verzögerungsschaltung (100, 200) aus einer Vielzahl von in Reihe geschalteten Verzögerungselementen (101, 201) mit mindestens einem Eingang (102; 202, 203) und mindestens einem Ausgang (103; 204, 205), wobei der Ausgang (103; 204) eines der Verzögerungselemente (101, 201) jeweils mit dem Eingang (102; 203) des nachfolgenden Verzögerungselements (101, 201) verbunden ist und wobei die Verzögerungsschaltung (100, 200) dazu eingerichtet ist, ein an dem Eingang (102; 202, 203) eines der Verzögerungselemente (101, 201) anliegendes Signal (108) nach einer inhärenten Verzögerungszeit über seinen Ausgang (103; 204) an den Eingang des nachfolgenden Verzögerungselements (101, 201) zu übertragen, wobei ein an dem Eingang (102; 202, 203) eines der Verzögerungselemente (101, 201) eingespeistes Signal einen Pegelwechsel (108) zwischen einem ersten diskreten Signalwert und einem zweiten diskreten Signalwert hervorruft und wobei dieser Pegelwechsel (108) über den Ausgang (103; 204) des Verzögerungselements (101, 201) jeweils an den Eingang (102; 202) des nachfolgenden Verzögerungselements übertragen wird,
- ein aus einer Vielzahl von Registern (105, 206) bestehendes Ausleseregister, wobei jedes Register (105, 206) einen Eingang (104) und einen Ausgang (106) aufweist, wobei der Eingang (104) jedes Registers (105, 206) jeweils mit dem Ausgang (103; 205) eines der Verzögerungselemente (101, 201) verbunden ist und der Ausgang (103; 205) jedes der Register (105, 206) mit einem Encoder verbindbar ist, und wobei jedes Register (105, 206) dazu eingerichtet ist, in einem durch ein in einer bestimmten Taktperiode auftretendes Taktsignal vorgegebenen Systemtakt (54) den an dem Eingang (104) des Registers (105, 206) anliegenden diskreten Signalwert zu speichern und über einen Ausgang (106) des Registers (105, 206) auszugeben,
- einen Pulsgenerator (130, 230) mit einem Eingang (131, 231) zum Aufschalten des eintreffenden Signals (108), wobei der Pulsgenerator (130, 230) dazu eingerichtet ist, das an seinem Eingang (131, 231) aufgeschaltete Signal (108) als eine Sequenz von Pegelwechseln (108) in die Verzögerungsschaltung (100, 200) durch Anlegen der Pegelwechsel (108) an den Eingang (102; 202) mindestens eines der Verzögerungselemente (101, 201) einzuspeisen,
**dadurch gekennzeichnet, dass** der Time-to-Digital-Konverter weiterhin aufweist:
- einen Austritts-Zähler (150) am Ende der in Reihe geschalteten Verzögerungselemente (101, 201), der mit dem Ausgang (103; 205) des letzten der in Reihe geschalteten Verzögerungselemente (101, 201) verbunden ist, wobei der Austrittszähler (150) dazu eingerichtet ist, das Austreten jedes Pegelwechsels (108) aus der Verzögerungsschaltung (100, 200) zu zählen.

9. Time-to-Digital-Konverter nach Anspruch 8, **dadurch gekennzeichnet, dass** der Austritts-Zähler (150) als Schieberegister ausgebildet ist, das eine Verkettung von mehreren Registern (153, 154) mit einem Eingang (155), einem Ausgang (156) und einem Takteingang (157) ist, wobei der Ausgang (156) eines Registers (153, 154) mit dem Eingang (155) des nachfolgenden Registers (153, 154) verbunden ist und die Takteingänge (157) aller Register (153, 154) mit dem Ausgang (103; 205) des letzten Verzögerungselements (101, 201) verbunden sind.

10. Time-to-Digital-Konverter nach Anspruch 9, **dadurch gekennzeichnet, dass** zwei Austritts-Zähler (150) vorgesehen sind, wobei der erste der zwei Austrittszähler (150) dazu eingerichtet ist, einen steigenden Flankenwechsel am Ausgang (103; 205) des letzten Verzögerungselements (101, 201) zu zählen, wobei der zweite der zwei Austritts-Zähler (150) dazu eingerichtet ist, einen fallenden Flankenwechsel am Ausgang (103; 205) des letzten Verzögerungselements (101, 201) zu zählen, und wobei die Takteingänge (157) der Register (153, 154) sowohl des ersten Austrittszählers (150) als auch des zweiten Austrittszählers (150) mit dem Ausgang (103; 205) des letzten Verzögerungselements (101, 201) verbunden sind.

11. Time-to-Digital-Konverter nach einem der Ansprüche 9 bis 10, **dadurch gekennzeichnet, dass** an jedem Ausgang (156) eines Registers (153, 154) des Schieberegisters (150) der Eingang eines weiteren Registers (151, 152) angeschlossen ist, wobei der Takteingang des weiteren Registers (151, 152) an den Systemtakt (54) angeschlossen ist.

12. Time-to-Digital-Konverter nach einem der Ansprüche 8 bis 11, **dadurch gekennzeichnet, dass** die Verzögerungsschaltung (200) als Addierer ausgebildet ist,
- wobei jedes der Verzögerungselemente (201) der Verzögerungsschaltung (200) ein Ein-Bit-Volladdierer ist, der zwei Summanden-Eingänge (202) und einen Eingang (203) für ein Carry-In-Signal sowie einen Ausgang (204) für ein Carry-Out-Signal und einen Ausgang (205) für ein Summen-Bit aufweist,
- wobei der Ein-Bit-Volladdierer dazu ausgebildet ist, eine Addition aller drei Eingänge (202, 203) durchzuführen und das Summenergebnis als zweistellige Binärzahl auszugeben, wobei das niedrigste Bit der zweistelligen Binärzahl auf dem Ausgang (205) für das Summen-Bit und das höchste Bit der zweistelligen Binärzahl auf dem Ausgang (204) für das Carry-Out-Signal ausgeben werden,
- wobei einer der Summanden-Eingänge (202) mindestens eines der Verzögerungselemente (201) mit einem ersten Ausgang (a) des Pulsgenerators (230) verbunden ist,
- wobei der Eingang (203) für das Carry-In-Signal der Verzögerungselemente (201) jeweils mit dem Ausgang (204) für das Carry-Out-Signal des jeweils nächstvorderen Verzögerungselements (201) aus der Reihe der Verzögerungselemente (201) verbunden ist, und
- wobei der Ausgang (205) für das Summen-Bit jedes Verzögerungselements (201) mit dem Eingang (157) jeweils eines Registers (153, 154) des Ausleseregisters verbunden ist.

13. Time-to-Digital-Konverter nach einem der Ansprüche 8 bis 12, **dadurch gekennzeichnet, dass** der Pulsgenerator (230) zusätzlich mindestens einen Feedback-Eingang (fb) aufweist, der mit dem Ausgang (205) für das Summen-Bit eines auswählten Verzögerungselements (201) verbunden ist.

14. Time-to-Digital-Konverter nach einem der Ansprüche 12 bis 13, **dadurch gekennzeichnet, dass** einer der Summanden-Eingänge (202) eines weiteren der Verzögerungselemente (201) mit einem zweiten Ausgang (b) des Pulsgenerators (230) verbunden ist, wobei der Pulsgenerator (230) dazu eingerichtet ist, bei einen auf seinem Eingang aufgeschalteten Signal mindestens einen Pegelwechsel (108) in die Verzögerungsschaltung (200) durch Anlegen des mindestens einen Pegelwechsels (108) an den Eingang (202) mindestens des weiteren Verzögerungselements (201) einzuspeisen.

15. Time-to-Digital-Konverter nach einem der Ansprüche 8 bis 13, **dadurch gekennzeichnet, dass** das Ausleseregister der Verzögerungselemente in mehrere Registersegmente (207) eingeteilt ist.

## Claims

1. Method for time-to-digital conversion for determining the point in time when a signal arrives at a measuring device (10, 20);
- wherein the signal (108) arriving at the measuring device (10, 20) is fed into a delay circuit (100, 200) consisting of a plurality of delay elements (101, 201) connected in series, comprising an input (102; 202, 203) and an output (103; 204, 205), wherein the output (103; 204) of one of the delay elements (101, 201) is respectively connected to the input (102, 203) of the subsequent delay element is such a way that, after an inherent delay time, a signal (108) applied to the input (102; 202, 203) of one of the delay elements (101, 201) is transmitted via its output (103; 204) to the input (102, 203) of the subsequent delay element (101, 201),
- wherein the input signal at the input (102; 202, 203) of one of the delay elements (101, 201) causes a level change (108) between a first discrete signal value and a second discrete signal value, and wherein this level change (108) is respectively transmitted via the output (103; 204) of the delay element (101, 201) to the input (102; 203) of the subsequent delay element (101, 201), and
- wherein the output (103; 205) of each delay element (101, 201) is also connected to an input (104) of a register (105, 206) and the discrete signal value present at the input (104) of the register (105, 206) is stored in a system clock (54) specified by a clock signal occurring in a given clock period and is output via an output (106) of the register (105, 206).
- wherein the incoming signal (108) is fed into the delay circuit (100, 200) by means of a pulse generator (130', 230) as a sequence of level changes (108),
**characterized in that**
the output of each level change (108) at the end of the delay elements connected in series (101, 201) is counted in an output counter (150).

2. The method according to Claim 1, **characterized in that** a separate outlet meter (150) is provided for different level changes (108).

3. The method according to Claim 2, **characterized in that** each of the output counters (150) is designed as a shift register.

4. The method according to any one of the preceding claims, **characterized in that** the sequence of level changes (108) is fed into the delay circuit (100, 200) in such a way that a plurality of level changes (108) are in the delay circuit (100, 200) simultaneously.

5. The method according to Claim 4, **characterized in that,** in a sequence of signal values generated from the entirety of the registers (106, 206) during readout, the position of at least two of the plurality of edge changes (108) is summed up, and a numerical value is generated from the sum indicating the time of arrival of the signal (108) at the measuring device (10, 20).

6. The method according to any one of the preceding claims, **characterized in that** the series of registers (206) is divided into a plurality of register segments (207) of the readout register, and, for each register segment (207), a separate determination of the population of this register segment (207) is carried out with a specified discrete signal value.

7. The method according to Claim 6, **characterized in that** the sequence of level changes (108) fed into the delay circuit (100, 200) and/or a plurality of level changes (108) fed simultaneously into the delay circuit (100, 200) results in a maximum of one level change (108) in one register segment (207).

8. A time-to-digital converter comprising a control device designed to carry out the method according to any one of the preceding claims for determining the time of arrival of a signal (108) at the measuring device (10, 20) designed as a time-to-digital converter, wherein the time-to-digital converter (10, 20) comprises:
- a delay circuit (100, 200) consisting of a plurality of delay elements (101, 201) connected in series with at least one input (102; 202, 203) and at least one output (103; 204, 205), wherein the output (103; 204) of one of the delay elements (101, 201) is respectively connected to the input (102; 203) of the subsequent delay element (101, 201) and wherein the delay circuit (100, 200) is designed to transmit a signal (108) at the input (102; 202, 203) of one of the delay elements (101, 201) after an inherent delay time via its output (103; 204) to the input of the subsequent delay element (101, 201), wherein a signal fed into the input (102; 202, 203) of one of the delay elements (101, 201) causes a level change (108) between a first discrete signal value and a second discrete signal value and wherein this level change (108) is transmitted via the output (103; 204) of the delay element (101, 201) to the input (102; 202) of the subsequent delay element,
- a readout register consisting of a plurality of registers (105, 206), wherein each register (105, 206) comprises an input (104) and an output (106), wherein the input (104) of each register (105, 206) is respectively connected to the output (103; 205) of one of the delay elements (101, 201), and the output (103; 205) of each of the registers (105, 206) is respectively connected to an encoder, and wherein each register (105, 206) is configured to store the discrete signal value applied to the input (104) of the register (105, 206) in a system clock specified by a clock signal occurring in a given clock period (54) and to output it via an output (106) of the register (105, 206),
- a pulse generator (130, 230) with an input (131, 231) for switching on the incoming signal (108), wherein the pulse generator (130, 230) is configured to transfer the signal (108) connected at its input (131, 231) as a sequence of level changes (108) into the delay circuit (100, 200) by applying the level changes (108) to the input (102; 202) at least one of the delay elements (101, 201),
**characterized in that** the time-to-digital converter furthermore comprises:
- an output counter (150) at the end of the delay elements connected in series (101, 201) connected to the output (103; 205) of the last of the delay elements connected in series (101, 201), wherein the output counter (150) being configured to count the output of each level change (108) from the delay circuit (100, 200).

9. The time-to-digital converter according to Claim 8, **characterized in that** the output counter (150) is designed as a shift register, which is a chain of a plurality of registers (153, 154) with an input (155), an output (156) and a clock input (157), wherein the output (156) of one register (153, 154) is connected to the input (155) of the subsequent register (153, 154) and the clock inputs (157) of all registers (153, 154) are connected to the output (103; 205) of the last delay element (101, 201).

10. The time-to-digital converter according to Claim 9, **characterized in that** two output counters (150) are provided, wherein the first of the two output counters (150) is configured to count an increasing flank change at the output (103, 205) of the last delay element (101, 201), wherein the second of the two output counters (150) is configured to detect a decreasing flank change at the output (103; 205) of the last delay element (101, 201) and wherein the clock inputs (157) of the registers (153, 154) of both the first output counter (150) as well as the second output counter (150) are connected to the output (103; 205) of the last delay element (101, 201) .

11. Time-to-digital converter according to any one of the Claims 9 to 10, **characterized in that** the input of another register (151, 152) is connected at each output (156) of a register (153, 154) of the shift register (150), wherein the clock input of the further register (151, 152). is connected to the system clock (54).

12. The time-to-digital converter according to any one of the Claims 8 to 11, **characterized in that** the delay circuit (200) is designed as an adder,
- wherein each of the delay elements (201) of the delay circuit (200) is a one-bit full adder comprising two summand inputs (202) and one input (203) for a carry-in signal, as well as an output (204) for a carry-out signal and an output (205) for a sum bit,
- wherein the one-bit full adder is designed to add all three inputs (202, 203) and to output the sum result as a two-digit binary, wherein the lowest bit of the two-digit binary number is output at the output (205) for the sum bit and the highest bit of the two-digit binary on the output (204) is output for the carry-out signal,
- wherein one of the summand inputs (202) of at least one of the delay elements (201) is connected to a first output (a) of the pulse generator (230),
- wherein the input (203) for the carry-in signal of the delay elements (201) is connected to the output (204) for the carry-out signal of the delay element (201) next closest to the front from the series of delay elements (201), and
- wherein the output (205) for the sum bit of each delay element (201) is connected to the input (157) of each register (153, 154) of the readout register.

13. The time-to-digital converter according to any one of the Claims 8 to 12; **characterized in that** the pulse generator (230) additionally comprises at least one feedback input (fb) connected to the output (205) for the sum bit of a selected delay element (201).

14. The time-to-digital converter according to any one of the Claims 12 to 13, **characterized in that** one of the summand inputs (202) of another of the delay elements (201) is connected to a second output (b) of the pulse generator (230), wherein the pulse generator (230) is configured, in the case of a signal connected to its input, to feed at least one level change (108) into the delay circuit (200) by applying at least one level change (108) to the input (202) of at least the additional delay element (201).

15. The time-to-digital converter according to any one of the Claims 8 to 13, **characterized in that** the readout register of the delay elements is divided into a plurality of register segments (207).

## Revendications

1. Procédé de conversion temps-numérique, à l'aide duquel le moment d'arrivée d'un signal à un dispositif de mesure (10, 20) est déterminé,
- le signal (108) arrivant au dispositif de mesure (10, 20) étant alimenté dans un circuit de temporisation (100, 200) constitué d'une pluralité d'éléments de temporisation (101, 201) montés en série, qui comportent une entrée (102 ; 202, 203) et une sortie (103 ; 204, 205), la sortie (103 ; 204) de l'un des éléments de temporisation (101, 201) étant respectivement connectée avec l'entrée (102, 203) de l'élément de temporisation suivant, de telle sorte qu'après une temporisation inhérente, un signal (108) appliqué à l'entrée (102 ; 202, 203) de l'un des éléments de temporisation (101, 201) soit transmis par l'intermédiaire de sa sortie (103 ; 204) à l'entrée (102, 203) de l'élément de temporisation (101, 201) suivant,
- le signal alimenté provoquant à l'entrée (102 ; 202, 203) de l'un des éléments de temporisation (101, 201) un changement de niveau (108) entre une première valeur de signal discrète et une deuxième valeur de signal discrète et ledit changement de niveau (108) étant transmis par l'intermédiaire de la sortie (103 ; 204) de l'élément de temporisation (101, 201) chaque fois à l'entrée (102 ; 203) de l'élément de temporisation (101, 201) suivant et
- la sortie (103 ; 205) de chaque élément de temporisation (101, 201) étant chaque fois connectée également avec l'entrée (104) d'un registre (105, 206) et la valeur de signal discrète appliquée à l'entrée (104) du registre (105, 206) étant mémorisée selon une horloge de système (54) prédéfinie par un signal d'horloge se produisant dans une période d'horloge déterminée et éditée par l'intermédiaire d'une sortie (106) du registre (105, 206),
- le signal (108) arrivant étant alimenté au moyen d'un générateur d'impulsions (130', 230) sous la forme d'une séquence de changements de niveau (108) dans le circuit de temporisation (100, 200),
**caractérisé en ce que**
la sortie de chaque changement de niveau (108) à la fin des éléments de temporisation (101, 201) montés en série est comptée dans un compteur de sorties (150).

2. Procédé selon la revendication 1, **caractérisé en ce qu'**il est prévu chaque fois un compteur de sorties (150) séparé pour différents changements de niveau (108).

3. Procédé selon la revendication 2, **caractérisé en ce que** chacun des compteurs de sorties (150) est conçu sous la forme d'un registre à décalage.

4. Procédé selon l'une quelconque des revendications précédentes, **caractérisé en ce que** la séquence de changements de niveau (108) est alimentée dans le circuit de temporisation (100, 200) de telle sorte que plusieurs changements de niveau (108) se trouvent simultanément dans le circuit de temporisation (100, 200) .

5. Procédé selon la revendication 4, **caractérisé en ce que** dans une suite de valeurs de signaux générée par la totalité des registres (105, 206) lors de la lecture, chaque fois la position d'au moins deux des plusieurs changements de flanc (108) est totalisée et à partir de la somme est générée une valeur numérique, qui indique le moment de l'arrivée du signal (108) au dispositif de mesure (10, 20).

6. Procédé selon l'une quelconque des revendications précédentes, **caractérisé en ce que** la série des registres (206) est divisée en plusieurs segments (207) de registre du registre de lecture et pour chaque segment (207) de registre, une détermination de la population dudit segment (207) de registre a lieu séparément avec une valeur de signal discrète prédéfinie.

7. Procédé selon la revendication 6, **caractérisé en ce que** par la séquence de changements de niveau (108) alimentée dans le circuit de temporisation (100, 200) et / ou par plusieurs changements de niveau (108) alimentés simultanément dans le circuit de temporisation (100, 200), il se produit au maximum un changement de niveau (108) dans un segment (207) de registre.

8. Convertisseur temps-numérique, doté d'un système de commande configuré pour réaliser le procédé selon l'une quelconque des revendications précédentes pour déterminer le moment d'arrivée d'un signal (108) au dispositif de mesure (10, 20) conçu sous la forme d'un convertisseur temps-numérique, le convertisseur temps-numérique (10, 20) comportant :
- un circuit de temporisation (100, 200) constitué d'une pluralité d'éléments de temporisation (101, 201) montés en série avec au moins une entrée (102 ; 202, 203) et au moins une sortie (103 ; 204, 205), la sortie (103 ; 204) de l'un des éléments de temporisation (101, 201) étant respectivement connectée avec l'entrée (102 ; 203) de l'élément de temporisation (101, 201) suivant et le circuit de temporisation (100, 200) étant configuré pour transmettre après une temporisation inhérente, par l'intermédiaire de sa sortie (103 ; 204) un signal (108) appliqué à l'entrée (102 ; 202, 203) de l'un des éléments de temporisation (101, 201) à l'entrée de l'élément de temporisation (101, 201) suivant, un signal alimenté à l'entrée (102 ; 202, 203) de l'un des éléments de temporisation (101, 201) provoquant un changement de niveau (108) entre une première valeur de signal discrète et une deuxième valeur de signal discrète et ledit changement de niveau (108) étant transmis par l'intermédiaire de la sortie (103 ; 204) de l'élément de temporisation (101, 201) chaque fois à l'entrée (102 ; 202) de l'élément de temporisation suivant,
- un registre de lecture constitué d'une pluralité de registres (105, 206), chaque registre (105, 206) comportant une entrée (104) et une sortie (106), l'entrée (104) de chaque registre (105, 206) étant chaque fois connectée avec la sortie (103 ; 205) de l'un des éléments de temporisation (101, 201) et la sortie (103 ; 205) de chacun des registres (105, 206) pouvant être connectée avec un encodeur et chaque registre (105, 206) étant configuré pour mémoriser selon une horloge de système (54) prédéfinie par un signal d'horloge se produisant dans une période d'horloge déterminée la valeur de signal discrète appliquée à l'entrée (104) du registre (105, 206) et pour l'éditer par l'intermédiaire d'une sortie (106) du registre (105, 206),
- un générateur d'impulsions (130, 230), pourvu d'une entrée (131, 231) destinée à introduire le signal (108) arrivant, le générateur d'impulsions (130, 230) étant configuré pour alimenter le signal (108) introduit à son entrée (131, 231) sous la forme d'une séquence de changements de niveau (108) dans le circuit de temporisation (100, 200), par application du changement de niveau (108) sur l'entrée (102 ; 202) d'au moins l'un des éléments de temporisation (101, 201),
**caractérisé en ce que** le convertisseur temps-numérique comporte par ailleurs :
- un compteur de sorties (150) à la fin des éléments de temporisation (101, 201) montés en série, qui est connecté avec la sortie (103 ; 205) du dernier des éléments de temporisation (101, 201) montés en série, le compteur de sorties (150) étant configuré pour compter la sortie de chaque changement de niveau (108) hors du circuit de temporisation (100, 200).

9. Convertisseur temps-numérique selon la revendication 8, **caractérisé en ce que** le compteur de sorties (150) est conçu sous la forme d'un registre à décalage, qui est un enchaînement de plusieurs registres (153, 154) avec une entrée (155), une sortie (156) et une entrée d'horloge (157), la sortie (156) d'un registre (153, 154) étant connectée avec l'entrée (155) du registre (153, 154) suivant et les entrées d'horloge (157) de tous les registres (153, 154) étant connectées avec la sortie (103 ; 205) du dernier élément de temporisation (101, 201).

10. Convertisseur temps-numérique selon la revendication 9, **caractérisé en ce que** deux compteurs de sorties (150) sont prévus, le premier des deux compteurs de sorties (150) étant configuré pour compter un changement de flanc ascendant à la sortie (103 ; 205) du dernier élément de temporisation (101, 201),
le deuxième des deux compteurs de sorties (150) étant configuré pour compter un changement de flanc descendant à la sortie (103 ; 205) du dernier élément de temporisation (101, 201) et les entrées d'horloge (157) des registres (153, 154) aussi bien du premier compteur de sorties (150) que du deuxième compteur de sorties (150) étant connectées avec la sortie (103 ; 205) du dernier élément de temporisation (101, 201).

11. Convertisseur temps-numérique selon l'une quelconque des revendications 9 à 10, **caractérisé en ce que** sur chaque sortie (156) d'un registre (153, 154) du registre à décalage (150) est raccordée l'entrée d'un registre (151, 152) supplémentaire, l'entrée d'horloge du registre (151, 152) supplémentaire étant raccordée sur l'horloge de système (54).

12. Convertisseur temps-numérique selon l'une quelconque des revendications 8 à 11, **caractérisé en ce que** le circuit de temporisation (200) est conçu sous la forme d'un additionneur,
- chacun des éléments de temporisation (201) du circuit de temporisation étant un additionneur complet un bit, qui comporte deux entrées de sommation (202) et une entrée (203) pour un signal Carry-in, ainsi qu'une sortie (204) pour un signal Carry-out et une sortie (205) pour un bit de somme,
- l'additionneur complet un bit étant conçu pour procéder à une addition de toutes les trois sorties 202, 203) et pour éditer le résultat de la somme sous la forme d'un nombre binaire à deux chiffres, le bit le plus faible du nombre binaire à deux chiffres étant édité sur la sortie (205) pour le bit de somme et le bit le plus fort du nombre binaire à deux chiffres étant édité sur la sortie (204) pour le signal Carry-out,
- l'une des entrées de sommation (202) d'au moins l'un des éléments de temporisation (201) étant connectée avec une première sortie (a) du générateur d'impulsions (230),
- l'entrée (203) pour le signal Carry-in des éléments de temporisation étant connectée chaque fois avec la sortie (204) pour le signal Carry-out de l'élément de temporisation (201) chaque fois immédiatement antérieur dans la série des éléments de temporisation (201) et
- la sortie (205) pour le bit de somme de chaque élément de temporisation (201) étant connectée avec l'entrée (157) de chaque fois un registre (153, 154) du registre de lecture.

13. Convertisseur temps-numérique selon l'une quelconque des revendications 8 à 12, **caractérisé en ce que** le générateur d'impulsions (230) comporte en supplément au moins une entrée de feedback (fb) qui est connectée avec la sortie (205) pour le bit de somme d'un élément de temporisation (201) sélectionné.

14. Convertisseur temps-numérique selon l'une quelconque des revendications 12 à 13, **caractérisé en ce que** l'une des entrées de sommation (202) d'un autre des éléments de temporisation (201) est connectée avec une deuxième sortie (b) du générateur d'impulsions (230), lorsqu'un signal est introduit dans son entrée, le générateur d'impulsions (230) étant configuré pour alimenter au moins un changement de niveau (108) dans le circuit de temporisation (200) par application de l'au moins un changement de niveau (108) sur l'entrée (202) d'au moins l'élément de temporisation (201) supplémentaire.

15. Convertisseur temps-numérique selon l'une quelconque des revendications 8 à 13, **caractérisé en ce que** le registre de lecture des éléments de temporisation est divisé en plusieurs segments (207) de registre.
